(19) Europäisches Patentamt
European Patent Office
Office européen des brevets

(11) **EP 2 715 804 B1**

(12) **EUROPÄISCHE PATENTSCHRIFT**

(45) Veröffentlichungstag und Bekanntmachung des Hinweises auf die Patenterteilung:
**06.07.2016 Patentblatt 2016/27**

(21) Anmeldenummer: **11749329.6**

(22) Anmeldetag: **31.05.2011**

(51) Int Cl.:
*G02B 27/01* (2006.01)      *G06F 3/00* (2006.01)
*G09G 3/32* (2006.01)

(86) Internationale Anmeldenummer:
**PCT/DE2011/001181**

(87) Internationale Veröffentlichungsnummer:
**WO 2012/163312 (06.12.2012 Gazette 2012/49)**

(54) **BIDIREKTIONALES DISPLAY UND ANSTEUERUNG DESSELBEN**

BIDIRECTIONAL DISPLAY AND TRIGGERING THEREOF

AFFICHAGE BIDIRECTIONNEL ET COMMANDE DE CE DERNIER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**09.04.2014 Patentblatt 2014/15**

(73) Patentinhaber: **Fraunhofer Gesellschaft zur Förderung der angewandten Forschung E.V.
80686 München (DE)**

(72) Erfinder:
• **HEROLD, Rigo
  01067 Dresden (DE)**
• **RICHTER, Bernd
  01159 Dresden (DE)**
• **VOGEL, Uwe
  01324 Dresden (DE)**

(74) Vertreter: **Pfenning, Meinig & Partner mbB
Patent- und Rechtsanwälte
An der Frauenkirche 20
01067 Dresden (DE)**

(56) Entgegenhaltungen:
DE-A1-102006 030 541      US-A1- 2003 117 369
US-A1- 2006 145 365

**Beschreibung**

Die vorliegende Erfindung bezieht sich auf ein bidirektionales Display sowie die elektrische Ansteuerung desselben.

Solche bidirektionalen Displays können insbesondere zur Erfassung der Augenblickrichtung beispielsweise in sog. "Head-Mounted Displays" (HMDs) eingesetzt werden. Nachfolgend werden Ausführungsbeispiele für die erfindungsgemäßen bidirektionalen Displays daher auch vor allen Dingen anhand solcher HMDs beschrieben. Die erfindungsgemäßen bidirektionalen Displays lassen sich jedoch auch für andere Anwendungszwecke, beispielsweise für blickgesteuerte Bildsucher (view finder) in Digitalkameras zur Menüsteuerung einsetzen. Auch ist ein Einsatz im Bereich von Mikroskopen zur Nutzersteuerung, z.B. zur Bewegung eines Kreuztisches durch Blicksteuerung, möglich. Weitere Einsatzgebiete sind denkbar.

Aus dem Stand der Technik sind zunächst HMDs mit Augenverfolgungsfunktion (eye-tracking function) bekannt, die jeweils eine separate Komponente zur virtuellen Bildprojektion sowie zur Erfassung der Nutzerblick richtung besitzen (J. P. Rolland, H. Hua, P. Krishnashwamy: "Video-based eye tracking methods and algorithms in head-mounted displays", optics express (2006), Band 14, H.10, S. 4328-4350). Das Auge blickt dabei durch einen halbdurchlässigen Spiegel auf die reale Welt. Ein virtuelles Displaybild wird durch ein Okular vergrößert und über einen halbdurchlässigen Spiegel dem Auge dargestellt. Mit einer infraroten Bestrahlungsquelle wird das Auge angestrahlt und die Augenszene über einen zweiten halbdurchlässigen Spiegel durch eine Linse auf eine Kamera abgebildet. Aufgrund der räumlich getrennten Anordnung von Display und Kamera treten in solchen HMDs keine optischen oder elektrischen Überkopplungen auf. Diese Systemarchitektur kann jedoch aufgrund der zahlreichen Komponenten nur einen begrenzten Miniaturisierungsgrad sowie eine moderate Leistungsaufnahme erreichen.

Aus dem Stand der Technik (DE 10 2006 030 541 A1) sind darüber hinaus optische Anordnungen bekannt, bei denen auf einem gemeinsamen Substrat mindestens ein elektromagnetische Strahlung emittierendes Element samt mehrerer elektromagnetische Strahlung detektierender Elemente oder mindestens ein elektromagnetische Strahlung detektierendes Element samt mehrerer elektromagnetische Strahlung emittierender Elemente angeordnet sind. Die Strahlung emittierenden und die Strahlung detektierenden Elemente können dabei in CMOS-Technologie realisiert sein (bei den Strahlung emittierenden Elementen kann es sich um organische Leuchtdioden OLEDs handeln, bei den Strahlung detektierenden Elementen kann es sich um CMOS-Photodioden handeln). Die in DE 10 2006 030 541 A1 gezeigten Anordnungen können (siehe nachfolgend) die Basis des Anzeigearrays und des Kameraarrays für das erfindungsgemäße bidirektionale Display bilden (das dann durch eine erfindungsgemäße elektrische Ansteuerung ergänzt wird). Daher sind die DE 10 2006 030 541 A1 sowie die darin beschriebenen konkreten optischen Anordnungen als Aufbauten für Anzeige- und Kameraarrays Bestandteil der vorliegenden Erfindung.

Bidirektionale Displays, beispielsweise für "Head-Mounted Displays", zur Erfassung der Augenblickrichtung in Form von bidirektionalen OLED-Mikrodisplays können somit auf Basis der DE 10 2006 030 541 A1 besonders klein realisiert werden. Neben einer vorteilhaften Miniaturisierung bei einer hohen Funktionalität ergeben sich dabei jedoch verschiedene Probleme, um bei Betrieb einerseits dem Nutzer ein lichtstarkes virtuelles Bild zu projizieren und andererseits die Augenszene zur Blickverfolgung (eye tracking) robust zu erfassen. Aufgrund der Architektur eines bidirektionalen OLED-Mikrodisplays tritt innerhalb der verschachtelten Aktivmatrix (ineinander Verschachteln des Anzeigearrays und des Kameraarrays, siehe nachfolgend) ein optisches Übersprechen von den OLED-Pixeln (nachfolgend ganz allgemein auch als lichterzeugende Bildelemente bezeichnet) zu den benachbarten Kamerapixeln (nachfolgend auch als lichterfassende Elemente bezeichnet) auf. Dieses optische Übersprechen hat jedoch zur Folge, dass der Dynamikbereich des Ausgangssignals der lichterfassenden Elemente stark eingeschränkt wird. Darüber hinaus kommt es aufgrund der im Schaltkreis benachbarten Schaltungsteile nicht nur zu einem optischen, sondern auch zu einem elektrischen Übersprechen. Dieses elektrische Übersprechen hat dann zur Folge, dass z. B. durch kapazitives Überkoppeln auf Signalleitungen innerhalb des verschachtelten Display- und Kameraarrays das Signal der lichterfassenden Elemente gestört wird.

(Ein weiteres Problem, welches bei bidirektionalen Displays in HMDs auftritt, ist die optische Entkopplung zwischen der virtuellen Bildprojektion vom Mikrodisplay zur Netzhaut und der Abbildung der Augenszene auf die Kameramatrix des bidirektionalen Displays. Diese Entkopplung wird jedoch dadurch erreicht, dass die Augenszene im nahen Infrarot-Bereich erfasst wird. Systemseitig muss deshalb das Auge des Nutzers im nahen Infrarot-Bereich bestrahlt werden. Die Intensität der vom Nutzerauge reflektierten Infrarot-Strahlung unterliegt dabei im System verschiedenen Verlustmechanismen sowie auch gesetzlichen Beschränkungen der maximalen Bestrahlungsstärke. Bei einer nicht optimierten Dimensionierung der Systemkomponenten verschlechtert sich die Qualität des im bidirektionalen Mikrodisplay erfassten Augenszenebildes. Weiterhin steigt die Leistungsaufnahme des Systems an. Eine schlechte Bildqualität kann das "eye tracking" sogar unmöglich machen.)

Weitere bidirektionale Displays sind aus Druckschriften US2006/0145365 und US2003/0117369 bekannt.

Ausgehend vom Stand der Technik ist es daher die Aufgabe der vorliegenden Erfindung, bidirektionale Displays zur Verfügung zu stellen, die die vorstehend angesprochenen Probleme lösen, bei denen also eine ausreichende optische und/oder elektrische Entkopplung bei hohem Miniaturisierungsgrad sichergestellt ist.

Diese Aufgabe wird durch ein bidirektionales Display gemäß Anspruch 1 sowie ein Verfahren zur Ansteuerung eines solchen Displays gemäß Anspruch 16 gelöst. Vorteilhafte Ausgestaltungsvarianten lassen sich den abhängigen Ansprüchen entnehmen. Erfindungsgemäße Verwendungen sind Anspruch 17 entnehmbar.

Nachfolgend wird die vorliegende Erfindung zunächst allgemein, dann anhand verschiedener vorteilhafter Ausführungsvarianten beschrieben. Die in den einzelnen Ausführungsbeispielen in Kombination miteinander verwirklichten Einzelmerkmale der vorliegenden Erfindung müssen dabei nicht genau in der in den Ausführungsbeispielen gezeigten Kombination miteinander verwirklicht werden, sondern die Einzelmerkmale können auch auf andere Weise im Rahmen des durch die Patentansprüche vorgegebenen Schutzumfangs miteinander kombiniert werden. Insbesondere können einzelne der in einem bestimmten Ausführungsbeispiel gezeigten Merkmale auch weggelassen werden oder auch in andere der gezeigten Ausführungsbeispiele übernommen werden.

Die erfindungsgemäßen bidirektionalen Displays basieren auf einer verschachtelten und/oder überlagerten Array-Struktur eines Anzeigearrays (Displayarrays) und eines Kameraarrays, also auf einer Array-Struktur, die sowohl bildwiedergebend als auch bildaufnehmend ist. Je nach Anforderungen an das Auflösungsvermögen der Kamera einerseits und der Anzeige andererseits kann dabei z.B. ein lichterfassendes Element, also ein Kamerapixel, von mehreren lichterzeugenden Bildelementen, also von mehreren Bildpixeln, umgeben sein, oder auch z.B. ein Bildpixel von mehreren Kamerapixeln umgeben sein. Eine Anordnung, bei der in jeder Displayzeile abwechselnd Kamera- und Bildpixel angeordnet sind (Schachbrettmuster von Kamera- und Bildpixeln) ist ebenso denkbar wie andere Arten des ineinander Verschachtelns der lichterzeugenden Bildelemente und der lichterfassenden Elemente.

Sofern nachfolgend nichts Anderes gesagt ist, ist der spektrale Bereich der maximalen Emission der lichterzeugenden Bildelemente (z.B.: Intensitätsmaximum im sichtbaren Bereich) ausreichend vom spektralen Bereich der maximalen Empfindlichkeit der lichterfassenden Elemente (z.B.: im nahen Infrarot-Bereich) beabstandet, so dass bereits durch diese Maßnahme eine gewisse, wenn auch nicht ausreichende optische Entkopplung realisiert ist.

Ein erfindungsgemäßes bidirektionales Display weist somit ein Anzeigearray mit mehreren lichterzeugenden Bildelementen und ein Kameraarray mit mehreren lichterfassenden Bildelementen auf. Die beiden Arrays sind bevorzugt jeweils zeilenweise elektrisch ansteuerbar und bevorzugt auch zumindest abschnittsweise, besonders bevorzugt vollständig ineinander verschachtelt angeordnet (siehe vorstehende Erläuterungen zur Aktivrmatrix).

In der Regel handelt es sich sowohl beim Anzeigearray als auch beim Kameraarray um zweidimensionale Arrays. Es ist jedoch auch denkbar, z.B. eines dieser Arrays (z.B. das Kameraarray) lediglich eindimensional, also als eine einzelne Zeile, die verschachtelt in einer oder zwischen zwei Zeilen des anderen Arrays angeordnet ist, auszubilden.

Erfindungsgemäß ist eine zeitlich gesehen sequentielle elektrische Ansteuerung der beiden Arrays realisiert. Dabei kann insbesondere eine elektrische Ansteuerung des Anzeigearrays und des Kameraarrays so realisiert werden, dass während einer Lichterzeugung in einer Zeile des Anzeigearrays eine Lichterfassung mit der dieser Zeile nächstliegenden Zeile das Kameraarrays (ggf. zusätzlich auch mit weiteren Kamerazeilen) deaktiviert ist. Es kann somit insbesondere eine zeilensequentielle elektrische Ansteuerung des bidirektionalen Displays erfolgen: zunächst eine Lichterzeugung in einer ausgewählten Zeile des Anzeigearrays, erst anschließend, nachdem die Lichterzeugung in dieser Zeile beendet worden ist, ein Aktivieren der zu dieser Zeile des Anzeigearrays nächstliegenden Zeile des Kameraarrays und eine Bildaufnahme mit dieser Zeile des Kameraarrays.

Selbstverständlich umfasst die vorliegende Erfindung somit auch eine spaltenweise elektrische Ansteuerung statt einer zeilenweisen: Die Einteilung des/der Array(s) in Zeilen und in Spalten ist ja eine reine Definitionsfrage, so dass (bei Drehung des/der Array(s) um z.B. 90°) Spalten auch als Zeilen ansehbar sind, so dass eine entsprechende spaltenweise Ansteuerung der/des Arrays von der vorliegenden Erfindung ebenso umfasst ist.

In einer weiteren vorteilhaften Ausgestaltungsvariante erfolgt die erfindungsgemäße elektrische Ansteuerung des Anzeigearrays und des Kameraarrays so, dass während der (gleichzeitigen oder auch zeitlich versetzten) Lichterzeugung in mehreren, bevorzugt benachbarten Zeilen des Anzeigearrays die Lichterfassung mit den diesen mehreren Zeilen nächstliegenden Zeilen (also benachbart angeordneten) Zeilen des Kameraarrays deaktiviert ist.

Die konsequente Fortsetzung dieses Gedankens führt dann zu einer weiteren vorteilhaften Ausgestaltungsvariante der elektrischen Ansteuerung, bei der während einer Lichterzeugung in irgendeiner der Zeilen des Anzeigearrays jegliche Lichterfassung mit dem Kameraarray deaktiviert ist. In diesem Fall liegt somit eine zeitlich gesehen vollständige Separation der elektrischen Ansteuerung des Anzeigearrays und der elektrischen Ansteuerung des Kameraarrays vor. Wenn also irgendwo im Anzeigearray Licht erzeugt wird, ist das gesamte Kameraarray so geschaltet, dass in letzterem nirgendwo Licht erfasst wird.

Andererseits ist jedoch auch eine elektrische Ansteuerung des Anzeigearrays und des Kameraarrays möglich, bei der während einer Lichterzeugung in einer Zeile des Anzeigearrays (z.B. in der ersten, obersten Zeile) eine Lichterfassung mit einer Zeile des Kameraarrays, die nicht die dieser Zeile des Anzeigearrays nächstliegende Zeile des Kameraarrays ist, sondern einen ausreichenden Abstand von der gerade licherzeugenden Zeile aufweist, ermöglicht ist. Diejenige Zeile, mit der die Lichterfassung ermöglicht ist, kann dann insbesondere diejenige Zeile des Kameraarrays sein, die am weitesten entfernt von der gerade lichtaktiven Zeile des Anzeigearrays liegt. Selbstverständlich ist es dabei auch möglich, dass (zeitlich versetzt oder auch gleichzeitig) mehrere Zeilen des Anzeigearrays noch lichterzeugend sind, während bereits (zeitlich versetzt zueinander oder auch gleichzeitig) bereits mehrere in ausreichendem Abstand von den lichterzeugenden Zeilen des Anzeigearrays angeordnete Zeilen des Kameraarrays bereits eine Lichterfassung durchführen bzw. mit dieser begonnen haben.

Ebenso ist eine elektrische Ansteuerung möglich, bei der während einer Lichterfassung mit einer Zeile, mit mehreren Zeilen oder mit allen Zeilen des Kameraarrays in einer Zeile oder auch in mehreren Zeilen des Anzeigearrays ein Programmieren dieser letztgenannten Zeile(n) des Anzeigearrays und/oder ein Einschreiben von in der/den letztgenannten Zeile(n) darzustellen-den Daten in letztere Zeile(n) ermöglicht ist, wobei in der/den letztgenannten Zeile(n) dann lediglich das Programmieren und/oder das Einschreiben ermöglicht ist, nicht jedoch das mit dem Aussenden von Licht verbundene Darstellen der Daten.

Auch ist eine elektrische Ansteuerung möglich, bei der während des Belichtens des Kameraarrays mit einer externen Lichtquelle (insbesondere mit einer im nahen Infrarot emittierenden Lichtquelle) und/oder während des Lichterfassens mit mindestens einer der Zeilen des Kameraarrays in keiner der Zeilen des Anzeigearrays eine Lichterzeugung und/oder eine elektrische Aktivität ermöglicht ist.

In einer weiteren vorteilhaften Ausgestaltungsvariante liegt (für eine oder auch für mehrere Zeilen des Anzeigearrays) zwischen dem Ende des Programmierens von Zeilen und/oder dem Ende des Einschreibens von in diesen Zeilen darzustellenden Daten in diese Zeilen einerseits und dem Beginn der Lichterfassung (mit einer oder mehreren Zeilen des Kameraarrays) andererseits ein vorbestimmtes Zeitintervall $\Delta t$. Die Länge dieses Zeitintervalls beträgt dabei vorteilhafterweise mindestens ein Zehntel, bevorzugt mindestens ein Fünftel, bevorzugt mindestens die Hälfte der Zeitdauer $\Delta t_{KE}$ der Lichterfassung mit der/den Zeile(n) des Kameraarrays.

In einer weiteren bevorzugten Variante ist für alle Zeilen des Anzeigearrays die Zeitdauer $t_{AE}$ der Lichterzeugung gleich lang. Auch kann für alle Zeilen des Anzeigearrays die Zeitdauer $t_{AD}$ der Deaktivierung der Lichterzeugung und/oder der elektrischen Deaktivierung und/oder des Abschaltens der jeweiligen Zeile gleich lang sein.

Die Lichterfassung kann in allen Zeilen des Kameraarrays in ein und demselben Zeitintervall $t_{KE}$ erfolgen, wobei dann die Lichterzeugung in den einzelnen Zeilen des Anzeigearrays zeitlich versetzt zueinander und für alle Zeilen des Anzeigearrays außerhalb dieses Zeitintervalls $t_{KE}$ erfolgen kann.

Ebenso ist es aber auch möglich, dass sowohl die Lichterfassung in den einzelnen Zeilen des Kameraarrays als auch die Lichterzeugung in den einzelnen Zeilen des Anzeigearrays zeitlich versetzt zueinander erfolgt. Für alle Zeilen des Anzeigearrays erfolgt dann die Lichterfassung in der jeweils nächstliegend (benachbart) angeordneten Zeile des Kameraarrays außerhalb des Zeitintervalls der Lichterzeugung der entsprechenden Zeile des Anzeigearrays.

Erfindungsgemäß lässt sich der Begriff der Lichterzeugung in einer Zeile wie folgt definieren: Mit dieser Lichterzeugung kann ein Einschreiben von in dieser Zeile darzustellenden Daten in diese Zeile und/oder ein Programmieren dieser Zeile samt dem Darstellen von Daten in dieser Zeile samt dem Löschen der dargestellten Daten aus dieser Zeile gemeint sein. In diesem Fall umfasst der Begriff der Lichterzeugung in einer Zeile (oder auch im gesamten Anzeigearray) somit die gesamte Zeitspanne der elektrischen Aktivität dieser Zeile bzw. des ganzen Anzeigearrays.

Ebenso ist es jedoch erfindungsgemäß möglich, unter der Lichterzeugung lediglich das vorbeschriebene Einschreiben und/oder Programmieren samt dem vorbeschriebenen Darstellen von Daten zu verstehen (also ohne das anschließende Löschen der dargestellten Daten aus der Zeile). Auch lediglich das Darstellen samt dem Löschen kann hierunter verstanden werden. Schließlich kann unter dem Begriff der Lichterzeugung in der vorliegenden Erfindung auch ausschließlich das vorbeschriebene Darstellen von Daten in einer Zeile (oder im gesamten Array) verstanden werden.

Die erfindungsgemäßen elektrischen Ansteuerverfahren beim Anzeigearray und beim Kameraarray sind dann entsprechend dieser Definitionen bzw. der entsprechenden Zeitdauern für das Einschreiben und/oder Programmieren, das Darstellen von Daten und das Löschen von Daten anzupassen.

Ebenso kann unter der Lichterfassung in einer Zeile des Kameraarrays (oder auch im gesamten Kameraarray, sofern alle Kamerazeilen gleichzeitig betrieben werden) eine Einschaltverzögerung (bzw. deren Zeitdauer) bis zum Beginn der Zeilenintegration (also der Erfassung) der von einer externen Lichtquelle ausgehenden und auf die Zeile auftreffenden Lichtquanten, die Integration und schließlich auch das Auslesen des durch die Integration der einzelnen auftreffenden Photonen der externen Lichtquelle erzeugten Zeilensignals gemeint sein. Gemäß dieser Definition umfasst die Lichterfassung (bzw. deren Zeitdauer) somit die gesamte Phase der elektrischen Aktivität der Zeile des Kameraarrays (bzw. des gesamten Kameraarrays).

Ebenso ist es jedoch möglich (unter entsprechender Anpassung der Zeitsteuerung bzw. der einzelnen Zeitdauern bei der elektrischen Ansteuerung des Anzeigearrays und des Kameraarrays), die Lichterfassung lediglich als die die vorbeschriebene Integration und das vorbeschriebene Auslesen umfassende Phase zu definieren. Auch eine Definition als das lediglich die vorbeschriebene Einschaltverzögerung samt der vorbeschriebenen Integration umfassende Zeitintervall oder als ausschließlich das Zeitintervall der Integration ist möglich.

Erfindungsgemäß können die Lichterzeugung und die Lichterfassung mehrmals aufeinander folgend (also in Zyklen), bevorzugt in periodischen Abständen entsprechend der einzelnen im Display darzustellenden Displaybilder oder Frames durchgeführt werden (in jedem eine Lichterzeugung generierenden Zyklus erfolgt dann auch eine Lichterfassung, wobei das Verhältnis zwischen der Lichterzeugung in den einzelnen Zeilen des Anzeigearrays und der Lichterfassung mit den einzelnen Zeilen des Kameraarrays wie bei den vorbeschriebenen Ausführungsvarianten realisiert werden kann).

Bevorzugt emittiert das Anzeigearray (bzw. dessen einzelne lichterzeugende Bildelemente) für das menschliche Auge sichtbares Licht, darüber hinaus jedoch möglichst wenig, bevorzugt kein Infrarot-Licht. Demgegenüber erfasst das Kameraarray (bzw. dessen lichterfassende Elemente) bevorzugt Infrarot-Licht (bevorzugt im nahen Infrarot-Bereich), darüber hinaus jedoch möglichst wenig sichtbares Licht, bevorzugt kein sichtbares Licht.

Die lichterzeugenden Bildelemente bzw. Pixel des Anzeigearrays können organische Leuchtdioden OLEDs sein. Die lichterfassenden Elemente bzw. Pixel des Kameraarrays können Photodioden oder Phototransistoren sein. Die lichterzeugenden Bildelemente und die lichterfassenden Elemente können dabei entweder als separate oder auch als ineinander verschachtelte, sowie in CMOS-Technologie ausgebildete und/oder integrierte Matrizen realisiert sein.

Das bidirektionale Display kann ein Mikrodisplay sein, dessen lichterzeugende Bildelemente eine Seitenlänge im Bereich zwischen 4 und 40 $\mu$m aufweisen. Die Seitenlänge der lichterfassenden Elemente kann im Bereich zwischen 4 und 40 $\mu$m liegen.

Wie bereits beschrieben, kann die Integration der lichterzeugenden Bildelemente und der lichterfassenden Elemente bzw. die Verschachtelung des Anzeige- und des Kameraarrays der vorliegenden Erfindung wie in der DE 10 2006 030 541 A1 beschrieben erfolgen.

Nachfolgend wird die Erfindung anhand mehrerer Ausführungsbeispiele beschrieben.

Dabei zeigt

Figur 1     eine Skizze des Aufbaus eines erfindungsgemäßen Displays mit einem zweidimensionalen Anzeigearray und einem zweidimensionalen Kameraarray, wobei die Arrays in Form zweier übereinander gelegter Gitter ineinander verschachtelt sind;

Figur 2     eine zeitlich gesehen vollständige Separation der elektrischen Ansteuerung des Anzeigearrays und der elektrischen Ansteuerung des Kameraarrays, wie sie erfindungsgemäß verwirklicht werden kann, im Vergleich zu dem aus dem Stand der Technik bekannten Parallelbetrieb von Display (bzw. Anzeigearray) und Kamera(array);

Figur 3     mehrere erfindungsgemäß realisierte elektrische Ansteuerungen des Anzeigearrays und des Kameraarrays auf Zeilenbasis im Vergleich zum Parallelbetrieb aus dem Stand der Technik;

Figur 4     eine weitere elektrische Ansteuerung von Anzeigearray und Kameraarray gemäß der Erfindung;

Figur 5     eine Entladeschaltung einer Photodiode, wie sie als lichterfassendes Element im Rahmen der Erfindung eingesetzt werden kann; sowie

Figur 6     Abhängigkeiten im Signalfluss zur Blickerfassungsrichtung, wie sie sich in einem HMD mit erfindungsgemäßem bidirektionalen Display ergeben können.

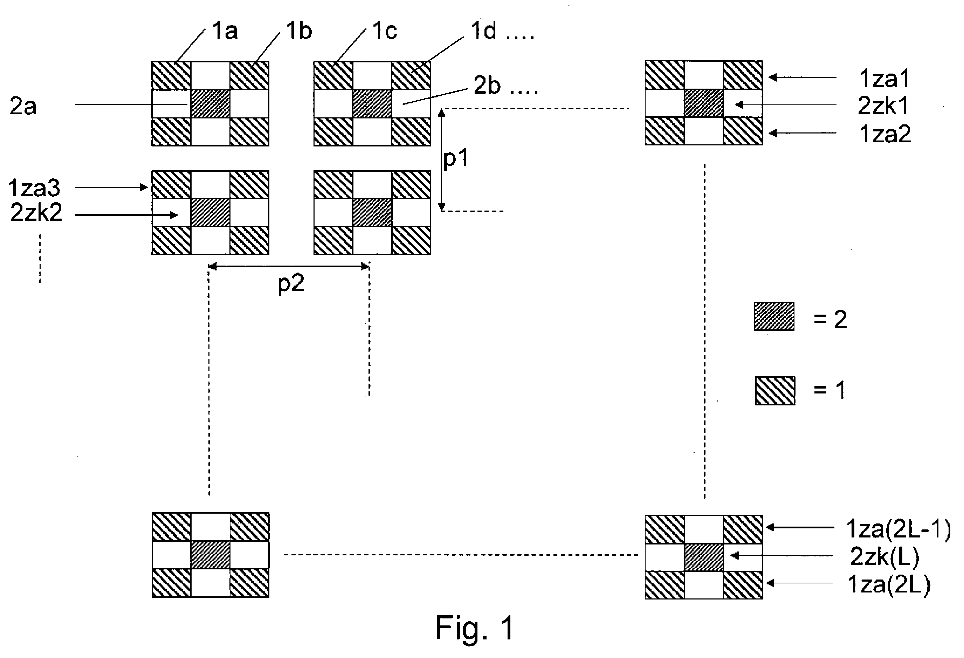

Figur 1 skizziert die Aktivmatrix eines erfindungsgemäßen bidirektionalen Displays mit einem zweidimensionalen Anzeigearray 1 und einem zweidimensionalen Kameraarray 2, wobei die Positionen der einzelnen lichterzeugenden Bildelemente 1a, 1b, ........., des Anzeigearrays den Kreuzungspunkten eines regelmäßigen quadratischen Gitters entsprechen und wobei die Positionen der einzelnen lichterfassenden Elemente 2a, 2b, ........., des Kameraarrays 2 ebenfalls den Positionen eines weiteren, regelmäßigen quadratischen zweidimensionalen Gitters entsprechen (die Gitterperiode p1 des Gitters des Anzeigearrays 1 entspricht dabei der halben Gitterperiode p2 des Gitters des zweidimensionalen Kameraarrays 2). Die beiden Gitter des Anzeigearrays 1 und des Kameraarrays 2 sind dabei versetzt zueinander übereinander gelegt, so dass jedes der lichterfassenden Elemente 2a, 2b, ........., des Kameraarrays 2 von jeweils vier einzelnen lichterzeugenden Bildelementen 1a, 1b, ........., des Anzeigearrays 1 in Form einer regelmäßigen Vierernachbarschaft umgeben ist.

Die erste Zeile 1za1 des so entstehenden bidirektionalen Displays entspricht so der ersten Zeile des Anzeigearrays 1, die zweite Zeile 2zk1 des bidirektionalen Displays der ersten Zeile des Kameraarrays 2. Die dritte Zeile 1za2 des bidirektionalen Displays entspricht der zweiten Zeile des Anzeigearrays 1. Die vierte Zeile lza3 des bidirektionalen Displays entspricht der dritten Zeile des Anzeigearrays 1. Die fünfte Zeile des bidirektionalen Displays (Zeile 2zk2) entspricht der zweiten Zeile des Kameraarrays 2, usw.

Das bidirektionale Display umfasst hier somit ein Anzeigearray 1 mit insgesamt 2L=10 Zeilen, die jeweils 10 Bildelemente 1a, 1b, ........., aufweisen, und ein Kameraarray 2 mit insgesamt L=5 Zeilen, die jeweils fünf lichterfassende Elemente 2a, 2b, ........., aufweisen. Das Anzeigearray 1 und das Kameraarray 2 sind jeweils (unabhängig voneinander) zeilenweise elektrisch ansteuerbar, so dass z.B. zeilenweise Daten in die einzelnen Zeilen des Anzeigearrays 1 eingeschrieben werden können, mit den einzelnen Zeilen dargestellt werden können und anschließend aus den einzelnen Zeilen wieder gelöscht werden können. Ebenso kann das Auslesen der mit den lichterfassenden Elementen 2a, 2b, ........., generierten elektrischen Signale zeilenweise erfolgen. Die elektrische Schaltung für ein solches zeilenweise Ansteuern des Anzeigearrays 1 und des Kameraarrays 2 ist dem Fachmann grundsätzlich bekannt.

Die der ersten Zeile 1za1 des Anzeigearrays 1 nächstliegende bzw. nächstliegend angeordnete Zeile des Kameraarrays 2 ist somit die Zeile 2zk1. Auch der zweiten Zeile 1za2 des Arrays 1 ist diese Zeile 2zk1 die nächstliegende Zeile des Kameraarrays 2. Die der dritten Zeile 1za3 des Anzeigearrays 1 nächstliegende Zeile des Kameraarrays 2 ist somit die zweite Zeile 2zk2 des Kameraarrays 2.

In der einfachsten Variante der erfindungsgemäßen elektrischen Ansteuerung wird somit während der Lichterzeugung in der ersten Zeile 1za1 (und der zweiten Zeile 1za2) des Anzeigearrays 1 die Lichterfassung mit der nächstliegenden Zeile 2zk1 deaktiviert (also die Kameraerfassung in dieser Zeile ausgeschaltet). Dies kann entsprechend mit den übrigen Zeilen 1za3, lza4, ......... des Anzeigearrays 1 entsprechend paarweise durchgeführt werden. Selbstverständlich lassen sich auch z.B. alle Zeilen 2zk des Kameraarrays 2 deaktivieren, während in irgendeiner Zeile 1za des Anzeigearrays 1 eine Lichterzeugung stattfindet. Weitere Details zu den erfindungsgemäßen elektrischen Ansteuerungen der beiden Arrays 1,2 werden nachfolgend beschrieben.

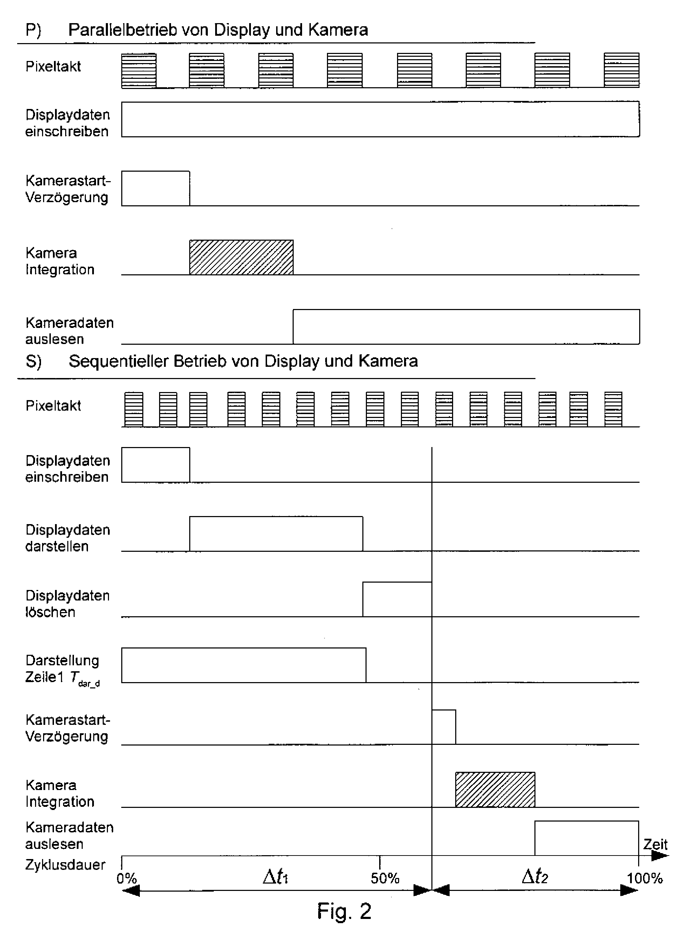

Figur 2 zeigt eine erste elektrische Ansteuerung des Anzeigearrays 1 und des Kameraarrays 2 aus Figur 1 gemäß der Erfindung (untere Bildhälfte: S)), bei der zeitlich gesehen eine vollständige Separation der elektrischen Ansteuerung des Anzeigearrays 1 bzw. der elektrischen Aktivität dieses Arrays einerseits und der elektrischen Ansteuerung des Kameraarrays 2 bzw. der elektrischen Aktivität des letzteren Arrays andererseits erfolgt, im Vergleich zu einem aus dem Stand der Technik bekannten Parallelbetrieb P) des Anzeigearrays ("Display") und des Kameraarrays ("Kamera").

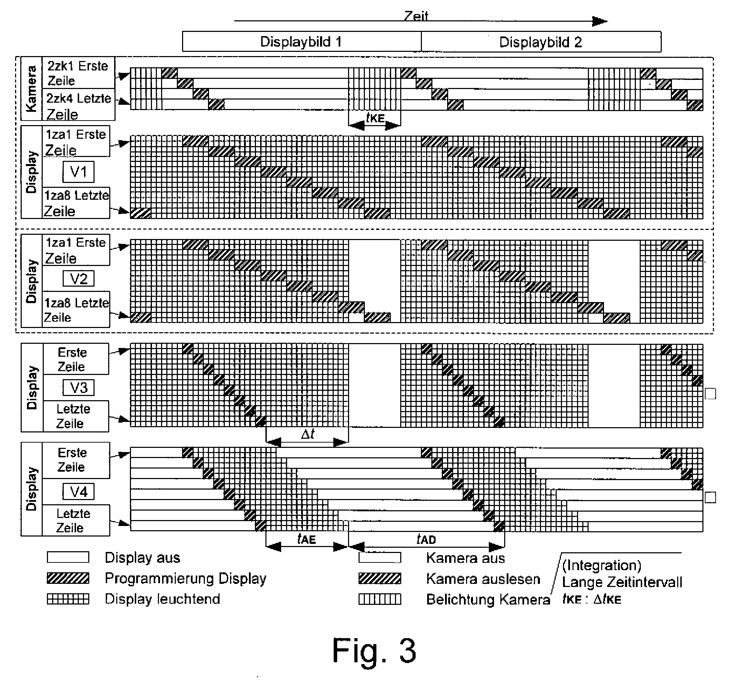

Die Figur 2 zeigt einen Zyklus der Bilddarstellung der Zeitdauer $\Delta t_1 + \Delta t_2$ (also die Erzeugung eines Displaybildes, im Rahmen der Erfindung auch als Lichterzeugung in den einzelnen Zeilen bezeichnet). Während dieses Zyklus erfolgt durch das hier Infrarotsensitive Kameraarray ebenfalls die Erfassung des auf die lichterfassenden Elemente 2a, 2b, ........., auftreffenden Infrarot-Lichts (im Rahmen der Erfindung auch als Lichterfassung mit den einzelnen Zeilen des Kameraarrays bezeichnet). Im nächsten Zyklus (hier nicht dargestellt) erfolgt dann die Darstellung eines gegebenenfalls geänderten Displaybildes (vgl. hier z.B. "Displaybild 2" in Figur 3).

Der Betrieb P) beschreibt ein paralleles Ansteuerverfahren, bei dem das Anzeigearray 1 innerhalb der Aktivmatrix des bidirektionalen Displays zeilenweise programmiert wird und bei dem die Integration im Kameraarray 2 und auch das Auslesen der Kameradaten in den einzelnen Zeilen des Kameraarrays 2 während des Einschreibens und Darstellens der Daten in den einzelnen Zeilen des Anzeigearrays 1 ("Displaydaten einschreiben") erfolgt. Die zeitliche Bezugsgröße aller in P) beschriebenen Vorgänge ist der Pixeltakt. Es wird z.B. mit jedem Pixeltakt ein neuer Bildpunkt in das Anzeigearray einprogrammiert. Das in P) dargestellte Intervall der Kamerastart-Verzögerung dient als dynamischer Zeitpuffer, um innerhalb einer Zykluszeit die Kameraintegrationszeit anzupassen. Im Betrieb muss die Kameraintegration abhängig von der einfallenden Lichtmenge auf die lichterfassenden Elemente angepasst werden, um einen hohen Dynamikbereich zu realisieren.

Demgegenüber sind in der erfindungsgemäßen elektrischen Ansteuerung S) im unteren Teil der Figur die elektrische Aktivität im Anzeigearray 1 ("Display"), in die u.a. auch die gesamte Lichterzeugung in den einzelnen Zeilen des Anzeigearrays 1 fällt, und die elektrische Aktivität des Kameraarrays 2, während der die Lichterfassung mit den einzelnen Zeilen des Kameraarrays 2 erfolgt, vollständig voneinander getrennt: In einem ersten Zeitabschnitt $\Delta t_1$ (hier entsprechend ca. der ersten 60 % der Zyklusdauer) erfolgt ausschließlich eine elektrische Aktivität im Anzeigearray 1, wohingegen im sich anschließenden zweiten Abschnitt $\Delta t_2$ des Zyklus (hier entsprechend ca. der letzten 40 % der Zeitdauer des Zyklus) ausschließlich eine elektrische Aktivität im Kameraarray 2, nicht jedoch im Anzeigearray 1, stattfindet. Mit anderen Worten: In $\Delta t_1$ erfolgt ausschließlich eine Ansteuerung des Anzeigearrays 1, während in $\Delta t_2$ ausschließlich eine Ansteuerung des Kameraarrays 2 erfolgt.

Das Einschreiben der Daten in das Anzeigearray, das Darstellen dieser Daten sowie das Löschen dieser Daten in den einzelnen Zeilen entspricht dabei in diesem Beispiel der Lichterzeugung im Anzeigearray. Die Verzögerung beim Kamerastart, die Signalakkumulation ("Kameraintegration") und das Auslesen der Kameradaten in den einzelnen Zeilen des Kameraarrays 2 entspricht hier der Lichterfassung mit den Zeilen des Kameraarrays 2. Während des Kamerastarts, der Kameraintegration und des Auslesens der Kameradaten ist somit das in Figur 1 gezeigte OLED-Anzeigearray 1 komplett dunkel geschaltet.

Figur 3 zeigt insgesamt drei erfindungsgemäße elektrische Ansteuerungen des Anzeigearrays 1 und des Kameraarrays 2 aus Figur 1 (diese Ansteuerungen bzw. Timings gemäß der vorliegenden Erfindung sind mit den Bezeichnungen V2, V3 und V4 versehen). Somit zeigt die Ordinate in Figur 3 unterschiedliche elektrische Ansteuerungen des Anzeigearrays 1 bzw. des Kameraarrays 2 und die Abszisse zeigt den Zeitverlauf der Lichterzeugung in den einzelnen Zeilen des Anzeigearrays 1 und der Lichterfassung in den einzelnen Zeilen des Kameraarrays 2. (Sowohl im Anzeigearray 1, von dem hier zur vereinfachten Darstellung lediglich acht einzelne Zeilen 1za1 bis 1za8 gezeigt sind, als auch im Kameraarray 2, von dem hier zur vereinfachten Darstellung lediglich insgesamt vier einzelne Zeilen 2zk1 bis 2zk4 gezeigt sind, erfolgt die Ansteuerung somit zeilenweise.) "Displaybild 1" zeigt dabei einen ersten Zyklus (vgl. Figur 2), "Displaybild 2" einen darauf folgenden identischen, zweiten Zyklus.

Der oberste Abschnitt ("Kamera") der Ordinate zeigt somit die zeilenweise Ansteuerung der einzelnen Zeilen 2zk des Kameraarrays 2 von der ersten bis zur letzten Zeile: Lediglich während des für alle Zeilen gleichen Zeitintervalls $t_{KE}$ (dessen Länge $\Delta t_{KE}$ hier beispielsweise 5 msek beträgt) erfolgt somit eine gleichzeitige Lichterfassung mit den gezeigten Zeilen 2zk1 bis 2zk4 des Kameraarrays 2 (im gezeigten Fall entspricht die Lichterfassung in den Kamerazeilen einem Zeitintervall $t_{KE}$, während dessen - inklusive einer ggf. vorhandenen Einschaltverzögerung - eine Integration der auftreffenden Lichtquanten in den einzelnen Zeilen der Kamera 2 erfolgt). Das Auslesen der einzelnen Kamerazeilen erfolgt jeweils zeitversetzt im Anschluss an das Zeitintervall $t_{KE}$.

Der zweitoberste Abschnitt der Ordinate ("Display V1") zeigt den zugehörigen Zeitverlauf der Lichterzeugung in den einzelnen Zeilen 1za des Anzeigearrays 1 im Fall des aus dem Stand der Technik bekannten Parallelbetriebs von Display und Kamera (vgl. auch P) in Figur 2). Bei dieser bekannten elektrischen Ansteuerung V1 von Anzeigearray 1 und Kameraarray 2 erfolgt somit auch während der Lichterfassung mit den einzelnen Zeilen der Kamera im Intervall $t_{KE}$ eine elektrische Aktivität im Anzeigearray 1 in (je nach Zeile des Anzeigearrays) Form des Einschreibens von Displaydaten in eine Zeile des Anzeigearrays ("Programmierung Display") oder in Form des Darstellens oder des Löschens der entsprechenden Displaydaten (hier zusammengefasst unter "Display leuchtend"). Im Stand der Technik sind somit beim Parallelbetrieb die elektrischen Aktivitäten im Anzeigearray 1 einerseits und im Kameraarray 2 andererseits nicht getrennt.

Der mittlere Ordinatenabschnitt ("Display V2") zeigt, in Verbindung mit dem oberen Ordinatenabschnitt ("Kamera") ein erfindungsgemäßes Verfahren, nachfolgend auch als Timing V2 bezeichnet, zur elektrischen Ansteuerung des Anzeigearrays 1 und des Kameraarrays 2 aus Figur 1. Definiert man die Lichterzeugung in einer Zeile 1za des Anzeigearrays als denjenigen Zeitabschnitt, während dessen ein oder mehrere lichterzeugende Bildelemente dieser Zeile Daten darstellen (also leuchten, "Display leuchtend"), so sieht man, dass während dieser so definierten Lichterzeugung in den einzelnen Zeilen des Displays bei der elektrischen Ansteuerung bzw. dem Timing V2 jeweils keine Lichterfassung in einer der Zeilen des Kameraarrays 2 erfolgt ("Kamera aus").

Erst wenn die Lichterzeugung in den Zeilen des Anzeigearrays beendet ist ("Display aus"), erfolgt im Timing V2 eine elektrische Aktivität im Kameraarray 2 in Form der Lichterfassung während des Intervalls $t_{KE}$ (wobei diese Lichterfassung hier für alle Zeilen des Kameraarrays gleichzeitig erfolgt und die Einschaltverzögerung bis zum. Beginn der Kameraintegration und die Integration in den Kamerazeilen umfasst).

Während der Lichterfassung mit der Kamera 2 (im Intervall $t_{KE}$) erfolgt somit keine Lichterzeugung im Anzeigearray 1, sondern lediglich ein Programmieren der letzten beiden Zeilen des Anzeigearrays 1 (auch das hier definitionsgemäß nicht von der Lichterfassung in der Kamera 2 im Intervall $t_{KE}$ umfasste zeilenweise aufeinanderfolgend durchgeführte Auslesen der Kamera erfolgt hier auch im nachfolgenden Zyklus) während der Lichterzeugung im Anzeigearray 1. Das Programmieren einer Displayzeile umfasst hier das Einschreiben von Daten in diese Displayzeile und das vorangehende Löschen der alten Daten.

Im vorliegenden Fall erfolgt hier somit keine vollständige Separation der elektrischen Ansteuerung des Anzeigearrays 1 einerseits und derjenigen des Kameraarrays 2 andererseits, da die Programmierung der letzten beiden Zeilen des Displays noch während der Belichtung der Kamera erfolgt und das Auslesen der Kamera noch erfolgt, während das Display leuchtet.

Es zeigt sich, dass dieses Timing V2 zwar bereits zu einer verbesserten optischen Entkopplung des Anzeigearrays 1 einerseits und des Kameraarrays 2 andererseits führt. Jedoch kann erfindungsgemäß die elektrische Entkopplung der beiden Arrays noch dadurch verbessert werden, dass während der (hier die Einschaltverzögerung und die Integration umfassenden) Lichterfassung mit der Kamera ("Belichtung Kamera") keinerlei elektrische Aktivität im Anzeigearray 1 stattfindet. Diese Variante ist im Timing V3 gezeigt: Letzteres ist grundsätzlich wie das Timing V2 realisiert, die Programmierung der Displayzeilen erfolgt jedoch so, dass sich für jede Zeile des Anzeigearrays zwischen dem Ende des Programmierens dieser Zeile und dem Beginn der Lichterfassung mit dem Kameraarray 2 (Beginn des Zeitintervalls $t_{KE}$) eine vorbestimmte Pause mindestens der Zeitdauer $\Delta t$ (wobei $\Delta t$ hier z.B. 5 msek beträgt), ergibt. Sämtliche elektrische Aktivität des Anzeigearrays 1 findet somit außerhalb des Zeitintervalls $t_{KE}$ statt.

Bei der elektrischen Ansteuerung V3 des Anzeigearrays 1 und des Kameraarrays 2 ergibt sich im in Figur 1 gezeigten OLED-basierten Anzeigearray 1 im Verlauf der Zeit ausgehend vom Moment des Beendens der Zeilenprogrammierung im Display (also vom Beginn des mit "Display leuchtend" gekennzeichneten Zeitabschnitts in Figur 3) mit zunehmender Zeitdauer des Leuchtens eine Abnahme der Leuchtstärke des Displays. Dies liegt daran, dass die Leuchtfläche gepulst betrieben wird und sich somit im Mittel für den Betrachter eine um das Pulsverhältnis reduzierte Helligkeit ergibt.

Im Timing V3 erfolgt die Unterbrechung der Lichterzeugung in den einzelnen Zeilen des Anzeigearrays (während des Zeitintervalls $t_{KE}$, in dem eine Belichtung der Kamera erfolgt), für die einzelnen Zeilen 1za des Anzeigearrays 1 zu unterschiedlichen Zeitpunkten nach dem Ende der Zeilenprogrammierung ("Programmierung Displays"). Somit ist zwar sichergestellt, dass die einzelnen Displayzeilen 1za in einem Zyklus insgesamt über ein und dieselbe Zeitdauer lichterzeugend bzw. leuchtend sind (Zeitdauer vom Ende der Programmierung der Zeile in einem Zyklus, z.B. "Displaybild 1" in Figur 3, bis zum Beginn der nächsten Zeilenprogrammierung in derselben Zeile im nächsten Zyklus, vgl. "Displaybild 2" in Figur 3, abzüglich der Länge $\Delta T_{KE}$ des Intervalls $t_{KE}$). Andererseits nimmt der Betrachter des Anzeigearrays aufgrund der hohen Displaybild- bzw. Framerate von z.B. 400 Hz letztendlich das Integral über die im vorbeschriebenen Zeitraum je Zyklus abgegebenen Leuchtstärke der einzelnen Zeilen des Anzeigearrays 1 wahr. Erfolgt nun die Unterbrechung der Lichterzeugung in den einzelnen Zeilen (ausgehend vom Ende der Zeilenprogrammierung) zu unterschiedlichen Zeitpunkten, so ergeben sich aufgrund der vorbeschriebenen Abnahme der Leuchtstärke im Verlauf der Zeit über den Zyklus für die vom Betrachter wahrgenommenen Bildhelligkeiten der Zeilen gemäß des vorbeschriebenen Integrals unterschiedliche Werte. Mit anderen Worten erscheinen diejenigen Zeilen des Anzeigearrays, in denen die Unterbrechung der Lichterzeugung während des Zeitintervalls $t_{KE}$ zu einem früheren Zeitpunkt nach dem Ende der Zeilenprogrammierung stattfindet, für den Betrachter dunkler, als diejenigen Zeilen, in denen die Unterbrechung der Lichterzeugung während des Intervalls $t_{KE}$ zu einem späteren Zeitpunkt nach dem Ende der Zeilenprogrammierung stattfindet. Dies ist jedoch nicht erwünscht.

Das vorbeschriebene Problem wird in der elektrischen Ansteuerung V4 bzw. im entsprechenden Timing wie folgt gelöst. Zwar erfolgt wie beim Timing V3 in allen Zeilen 2zk des Kameraarrays während ein und desselben Zeitintervalls $t_{KE}$ die Lichterfassung. Zusätzlich erfolgt die Lichterzeugung in unterschiedlichen Zeilen 1za des Anzeigearrays jeweils zeitlich versetzt (jeweils beginnend mit dem Ende der Programmierung der entsprechenden Zeile, wobei dann für jede der Zeilen 1za die Lichterzeugung außerhalb des Zeitintervalls $t_{KE}$, also außerhalb der Lichterfassung in den Zeilen 2zk des Kameraarrays 2 erfolgt) und die Zeitdauer der Lichterzeugung $t_{AE}$ ("Display leuchtend" umfassend die Darstellung der Displaydaten in der jeweiligen Zeile beginnend mit dem Ende der Programmierung der entsprechenden Anzeigezeile) ist für jede Zeile 1za des Anzeigearrays gleich lang. Mit anderen Worten ist die Zeitdauer $t_{AE}$ der Lichterzeugung für alle Zeilen 1za identisch. Auch die Zeitdauer $t_{AD}$, in der die Lichterzeugung der einzelnen Displayzeilen bzw. Anzeigezeilen 1za deaktiviert ist (also die Dauer vom Ende der Lichterzeugung in einer Zeile in einem Zyklus bis zum Beginn der Lichterzeugung in dieser Zeile im nächsten Zyklus) ist für alle Zeilen des Anzeigearrays 1 identisch. Somit ist sichergestellt, dass für jede Zeile 1za des Anzeigearrays 1 das Zeitintervall $t_{KE}$ der Kamerabelichtung in ein Zeitintervall fällt, in dem die entsprechende Zeile des Anzeigearrays 1 ausgeschaltet ist und das Verhältnis der Zeitdauer des Ausschaltens der Displayzeile und des Lichterzeugens mit der Displayzeile gleich ist. Die vorbeschriebene Problematik des Timings V3 tritt somit in der elektrischen Ansteuerung der Arrays 1, 2 gemäß des Timings V4 nicht auf.

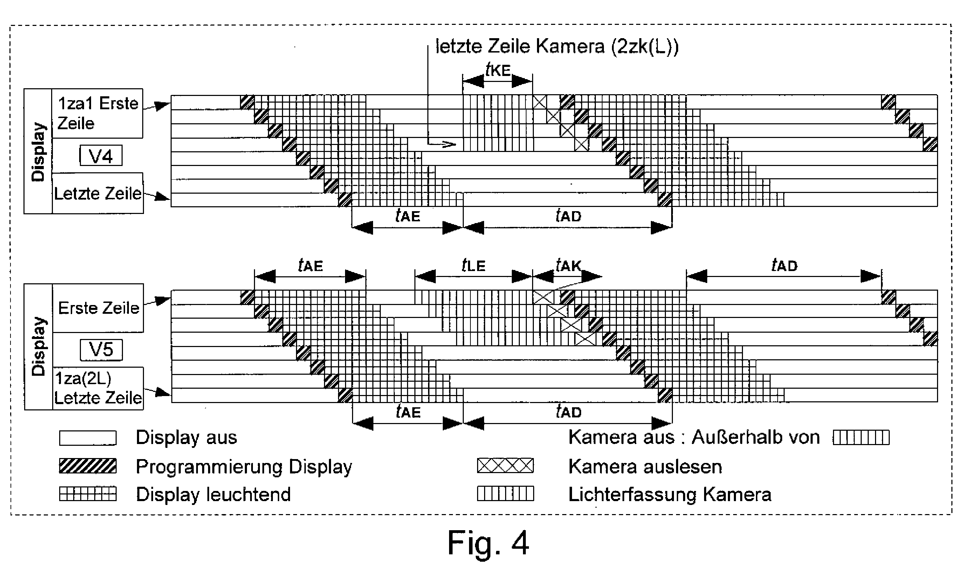

Eine weitere erfindungsgemäße elektrische Ansteuerung des Anzeigearrays 1 und des Kameraarrays 2 aus Figur 1, nachfolgend auch als Timing V5 bezeichnet, zeigt im Vergleich zum vorbeschriebenen Timing V4 Figur 4 (in dieser Darstellung ist der Zeitablauf der elektrischen Ansteuerung des Kameraarrays 2 dem Zeitablauf der elektrischen Ansteuerung des Anzeigearrays 1 überlagert dargestellt; auch hier sind wieder lediglich vier Zeilen 2zk des Kameraarrays 2 und acht Zeilen 1za des Anzeigearrays 1 dargestellt).

Während beim vorbeschriebenen Timing V4 die Lichterfassung für alle Zeilen 2zk der Kamera zur selben Zeit (im Zeitintervall $t_{KE}$) stattfindet (lediglich der Zeitpunkt des Auslesens der einzelnen Kamerazeilen 2zk verschiebt sich entsprechend, erfolgt also zeitlich versetzt nach Ende des Intervalls $t_{KE}$), so ist dies im erfindungsgemäßen Timing V5 nicht mehr der Fall: Im Timing V5 erfolgt nicht nur die Lichterzeugung in den einzelnen Zeilen 1za des Anzeigearrays 1 während des Zeitintervalls $t_{AE}$ zeitlich versetzt zueinander, sondern es erfolgt auch die Lichterfassung in den einzelnen Zeilen 2zk zeitlich versetzt zueinander während derjenigen Zeitdauer $t_{AD}$, während der die entsprechende Zeile 1za des Anzeigearrays 1 jeweils deaktiviert bzw. abgeschaltet ist.

Mit anderen Worten läuft ein Zyklus im Timing V5 für eine einzelne Displayzeile 1za (z.B. Zeile 1za1) und die ihr nächstliegende Kamerazeile 2zk (z.B. Zeile 2zk1 als nächstliegende Zeile zur Displayzeile 1za1) wie folgt ab: Programmierung der Anzeigezeile 1za, Lichterzeugung in der Anzeigezeile 1za (während des Intervalls $t_{AE}$), Ende der Lichterzeugung in der Anzeigezeile 1za (die Anzeigezeile 1za bleibt dann über die Zeitdauer $t_{AD}$ ausgeschaltet), Beginn der elektrischen Aktivität in der entsprechenden Kamerazeile 2zk, also der Lichterfassung in dieser Kamerazeile (die Lichterfassung erfolgt dann während der Zeitdauer $t_{LE}$), Ende der Lichterfassung in der entsprechen-den Kamerazeile 2zk, Auslesen dieser Kamerazeile während des Zeitintervalls $t_{AK}$ und schließlich nach Ablauf des Kameraauslesens $t_{AK}$ Beginn des nächsten Zyklus bzw. des erneuten Programmierens der entsprechenden Anzeigezeile 1za.

Wie Figur 4 im Ordinatenabschnitt "Display V5" zeigt, beginnt dabei die elektrische Aktivität bzw. das Erfassen von Licht in der ersten Kamerazeile 2zk1 (nach Abschalten der dieser Zeile nächstliegenden Anzeigezeile 1za1) zu einem Zeitpunkt, zu dem die zu dieser ersten Kamerazeile 2zk1 am weitesten entfernt liegende, letzte Zeile 1za(2L) des Anzeigearrays 1 noch lichterzeugend geschaltet ist. Es muss somit sichergestellt werden, dass der Abstand der letzten Zeile(n) des Anzeigearrays 1 von der/den erste(n) Zeile (n) 2zk1, 2zk2, ........., des Kameraarrays so groß ist, dass ein Übersprechen des mit dieser/n letzte(n) Zeile(n) des Anzeigearrays 1 erzeugten Lichtes in die lichterfassenden Elemente 2 der ersten Zeile(n) des Kameraarrays 2 vernachlässigbar gering ist.

Das in Figur 4 gezeigte Timing V5 gemäß der vorliegenden Erfindung hat gegenüber demjenigen gemäß V4 den Vorteil, dass das je Zeile im Kameraarray 2 mögliche Länge des Zeitintervalls $t_{LE}$ für die Lichterfassung durch den Zeitversatz beim Lichterfassen größer ist, als die gemäß des Zeitintervalls $t_{KE}$ im Timing V4 (bei dem die Lichterfassung in allen Zeilen der Kamera gleichzeitig erfolgt) für die Lichterfassung in den einzelnen Zeilen zur Verfügung stehende Zeit $\Delta t_{KE}$ (Optimierung der maximalen Lichterfassungszeit, also der maximalen Integrationszeit der Kamerazeilen).

Erfindungsgemäß sind somit (beispielsweise über die Timings V2 bis V5) unterschiedliche zeilenbasierte sequentielle Ansteuerungen des Anzeigearrays und des Kameraarrays möglich, bei denen (siehe z.B. das Timing V4) die elektrische Ansteuerung bzw. elektrische Aktivität im Anzeigearray 1 einerseits und im Kameraarray 2 andererseits nahezu vollständig oder vollständig voneinander getrennt werden kann.

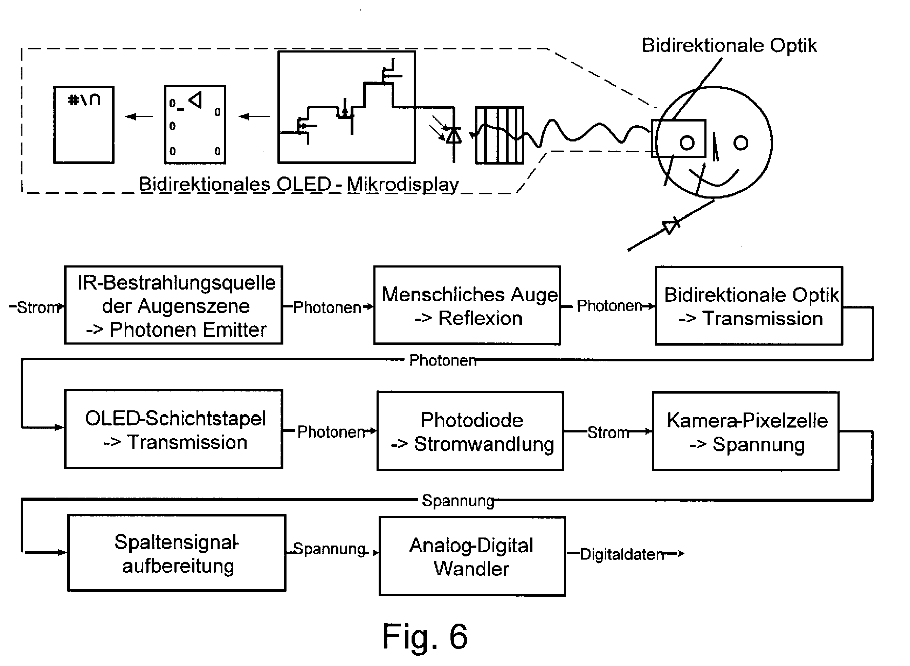

Um insbesondere das erfindungsgemäße bidirektionale Display und seine elektrische Ansteuerung im Bereich der HMDs (in Form von bidirektionalen OLED-Mikrodisplays) optimal ausnutzen zu können, wird erfindungsgemäß nachfolgend noch eine Vorgehensweise zur Dimensionierung der Systemkomponenten und deren Ansteuerung vorgeschlagen. Dazu zeigt Figur 6 die Abhängigkeiten zur Blickrichtungserfassung in einem erfindungsgemäßen HMD, das auf einem bidirektionalen OLED-Mikrodisplay gemäß Figur 1 basiert.

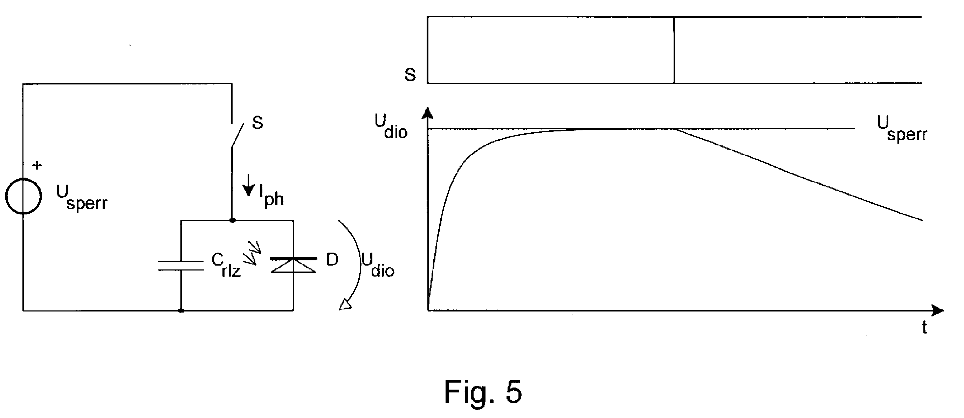

Das menschliche Auge darf nur bis zu einem gesetzlich festgelegten Grenzwert durch eine Infrarot-Bestrahlungsquelle 3 mit Photonen bestrahlt werden. Dieser Grenzwert ist u.a. von der Anordnung des IR-Strahlers 3 abhängig. Die Grenzwerte sind in den Normen DIN EN 62471 zur photobiologischen Sicherheit von Lampen und Lampensystemen sowie in der DIN EN 60825-1 zur Sicherheit für Laser-Einrichtungen festgelegt. Ein Teil der Photonen wird am Auge reflektiert und durch eine bidirektionale Optik transmittiert. Im nächsten Signalglied wird wieder ein Teil der Photonen durch einen OLED-Schichtstapel transmittiert und anschließend werden die Photonen innerhalb der Photodioden 2a, 2b, ........., bzw. innerhalb des Kameraarrays 2 zum Photostrom $I_{ph}$ gewandelt. Die Kamera-Pixelzellenschaltung wandelt den Photostrom in einen Spannungszug $U_{DIO}$ um (vgl. hierzu Figur 5 (t = Zeit)). Ein Analog-Digital-Wandler digitalisiert das Spannungssignal $U_{DIO}$, um es für einen Software-Eye-Tracking-Algorithmus nutzbar zu machen.

Eine robuste Augenbilderfassung erfordert allgemein einen hohen Spannungshub in der Pixelzelle bzw. dem lichterfassenden Element 2a, 2b, ........., des Kameraarrays 2. Innerhalb des in Figur 5 gezeigten Systems kann dieser Spannungshub $U_{DIO}$ nach der nachfolgenden Gleichung 1 berechnet werden:

$$U_{dio} = U_{sperr} - \frac{I_{ph} + I_s}{C_{rlz}} T_{int}$$

($U_{ido}$ = Spannung an Photodiode, $U_{sperr}$ = Betriebsspannung der Kamerapixelzelle, $I_{ph}$ = Photostrom, Is = Sperrstrom der Photodiode, $C_{RL2}$ = Raumladungskapazität der Photodiode).

Die Höhe des Photostroms $I_{ph}$ ist indirekt abhängig von der gesetzlich vorgeschriebenen maximalen Bestrahlungsstärke $H_{ir\_max}$ am menschlichen Auge sowie dem Reflexions- und Transmissionsverlust innerhalb des in Figur 6 gezeigten Systems. Der Photostrom $I_{ph}$ ist direkt abhängig von der spektralen Empfindlichkeit der integrierten lichterfassenden Elemente 2a, 2b, ..........

Nach Ermittlung des im System minimal zu erwartenden Photostroms $1_{ph\_min}$ (siehe auch nachfolgend) kann somit die maximal einstellbare bzw. mögliche Integrationszeit $T_{int}$ bestimmt werden ($T_{int}$ entspricht dann im Wesentlichen, d.h. bis auf gegebenenfalls vorhandene Kamerastartverzögerungszeiten in den einzelnen Zeilen, dem Zeitintervall $t_{KE}$ im Timing V4 bzw. dem Zeitintervall $t_{LE}$ im Timing V5). Eine zu hohe im System definierte maximale Integrationszeit $T_{int}$ erfordert eine höhere Pixeltaktfrequenz und eine damit verbundene erhöhte Leistungsaufnahme.

Um das gesamte System hinsichtlich der Robustheit der Augenbilderfassung sowie einer optimierte Leistungsaufnahme abzustimmen, ist folgendes Vorgehen zur Ermittlung der maximal einstellbaren Integrationszeit (bzw. der maximalen Zeit für die Lichterfassung mit einer Zeile 2zk des Kameraarrays während eines Frames bzw. eines Displaybildes) möglich:

- Berechnung der Transmissionseigenschaften des OLED-Schichtstapels bzw. der Aktivmatrix aus Anzeigearray und Kameraarray in Abhängigkeit der Wellenlänge $\lambda$ des auftreffenden Lichts z.B. durch Nutzung der dem Fachmann an sich bekannten Transfer-Matrix-Methode. (zu dieser Methode siehe Sernelius, Bo E.: Reflection from a metallic surface. Vorlesung, Universität Linköping, 2010.)

- Simulation oder Messung der spektralen, von der Wellenlänge $\lambda$ abhängigen Empfindlichkeit der im bidirektionalen OLED-Mikrodisplay gemäß der vorliegenden Erfindung integrierten lichterfassenden Elemente bzw. Photodioden oder Phototransistoren.

- Ermittlung einer maximal erreichbaren spektralen Empfindlichkeit durch Addition der Transmissionskurve der Aktivmatrix bzw. des OLED-Schichtstapels und der Kurve der spektralen Empfindlichkeit der lichterfassenden Elemente.

- Auswahl der maximalen Wellenlänge $\lambda$ des IR-Strahlers 3 im Wertebereich 800 nm < $\lambda$ < 1.000 nm, um im OLED-Schichtstapel bzw. in der Aktivmatrix sowie innerhalb der lichterfassenden Elemente bzw. der Photodioden eine hohe spektrale Empfindlichkeit erreichen zu können.

- Berechnung der maximal zulässigen Bestrahlungsstärke des Auges nach DIN EN 62471 und DIN EN 60825-1.
- Berechnung der optischen Transmissionseigenschaften des Kameraarrays im bidirektionalen Display.
- Abschätzung der minimal erreichbaren Reflexion am menschlichen Auge.

Basierend auf den vorhergehenden Berechnungen bzw. Abschätzungen kann der minimal erreichbare Photostrom $I_{ph\_min}$ innerhalb der Kamerapixelzelle bzw. innerhalb eines lichterfassenden Elementes 2a, 2b, ........., bestimmt bzw. abgeschätzt werden. Unter Bezugnahme auf diesen Wert $I_{ph\_min}$ ist nach der vorstehenden Gleichung 1 die maximal einstellbare Integrationszeit $T_{int}$ (bzw. die Zeit $t_{KE}$ oder $t_{AD}$ im Timing V4 bzw. V5) für $U_{DIO} \approx U_{SPERR}$ innerhalb der Kamerapixelzelle rechnerisch zu bestimmen (alternativ dazu kann $T_{int}$ auch durch Analogsimulation bestimmt werden).

Die ermittelte Integrationszeit $T_{int}$ dient dann als Grundlage zur Dimensionierung der optimalen Ansteuerung des bidirektionalen OLED-Mikrodisplays, also zur Wahl des Zeitintervalls in den in den Figuren 3 und 4 gezeigten erfindungsgemäßen Ansteuerungen der beiden Arrays 1,2.

Während im aus dem Stand der Technik bekannten Parallelbetrieb P) (vgl. Figur 2 oben) das Anzeigearray 1 kontinuierlich Daten darstellt und das darin verschachtelte Kameraarray 2 gleichzeitig kontinuierlich die Blickrichtung des Nutzers erfasst, wird mit den erfindungsgemäß angesteuerten bidirektionalen Displays das optische und/oder das elektrische Übersprechen zwischen den lichterzeugenden Bildelementen 1a, 1b, ........., und den lichterfassenden Elementen 2a, 2b, ........., minimiert oder sogar ganz verhindert. Dies hat den Vorteil, dass auch bei hohen Displayleuchtdichten im Anzeigearray 1 das aufgenommene Kamerabild des Kameraarrays 2 trotzdem für eine Bestimmung der Augenblickrichtung genutzt werden kann. Wesentlich hierfür ist die erfindungsgemäße Separation der Leuchtzeit des Anzeigearrays sowie der Aufnahme des Kamerabildes mit dem Kameraarray.

Wie bereits beschrieben, zeigt Figur 2 die Gegenüberstellung zwischen dem aus dem Stand der Technik bekannten parallelen Ansteuerverfahren und dem sequentiellen Ansteuerverfahren gemäß der vorliegenden Erfindung. In den erfindungsgemäßen sequentiellen Verfahren kann zuerst das Display eingeschrieben werden. Während dieser Phase ist die OLED leuchtend. Um für jede Bildzeile zeitlich die gleiche Helligkeit darzustellen, werden die Zeilen in der gleichen Reihenfolge wie beim Einschreiben gelöscht. Anschließend kann die OLED dunkel geschaltet werden und es beginnt erst dann das Integrationsintervall $T_{int}$ mit dem Kameraarray 2. Anschließend wird das Kameraarray 2 ausgelesen. Die erforderliche Pixeltaktfrequenz $f_{pixel}$ kann für die erfindungsgemäßen sequentiellen Ansteuerverfahren nach der nachfolgenden Gleichung (Gleichung 2) unter Einbezug der vorher berechneten maximalen Integrationszeit $T_{int}$ sowie der Display- und Kameraauflösung wie folgt berechnet werden.

$$f_{pixel} = \frac{N_{ein\_d} + N_{dar\_d} + N_{l\ddot{o}sch\_d} + N_{aus\_k}}{T_{zyk\_s} - T_{int}}$$

$N_{ein\_d} \approx N_{l\ddot{o}sch\_d} \approx$ Anzahl_Displayzeilen · Anzahl_Displayspalten,
$N_{dar\_d} =$ Anzahl_der_Pixeltakte_während_der_Leuchtphase,
$N_{aus\_k} \approx$ Anzahl_Kamerazeilen · Anzahl_Kameraspalten und

$$T_{zyk\_s} = \frac{1}{\text{Bildwiederholfrequenz}} = \frac{1}{f_{bild}}$$

Beim erfindungsgemäßen Timing V2 wird während der Display-Programmierung für die Dauer der Kamerabelichtung die OLED komplett dunkel geschaltet. Beim Timing V2 wird somit das Anzeigearray 1 für ein gewisses Zeitfenster ausgeschaltet, während der Display-Controller noch Daten einschreibt. Das erfindungsgemäße Timing V3 beschreibt das schnelle Programmieren der Display-Matrix und das Ausschalten des Displays während der Belichtungszeit und nach der Display-Programmierphase. Beim Timing V3 wird das Anzeigearray 1 für ein gewisses Zeitfenster ausgeschaltet, nachdem der Display-Controller alle Daten eingeschrieben hat.

Das erfindungsgemäße Timing V4 beschreibt einen rein sequentiellen Betrieb (vgl. Figur 2 S)), in dem die Display-Matrix zeilenweise programmiert und nach einer gewissen Leuchtdauer auch zeilenweise gelöscht wird. Nach dem Löschen der letzten Displayzeile erfolgt die Kamerabelichtung. Das Timing V4 gemäß der Erfindung lässt sich auch zum Displaydimmen einsetzen (Regeln der Helligkeit über die Pulsweite bzw. genauer gesagt über das Zeitintervall $t_{AD}$, während der die entsprechende Displayzeile ausgeschaltet ist, vgl. Figur 4). Die Gesamthelligkeit des erfindungsgemäßen bidirektionalen Displays kann somit durch eine Variation der Leuchtdauer für jede Displayzeile gesteuert werden. Beim Timing V4 werden die einzelnen Anzeigearrayzeilen somit stufenförmig ausgeschaltet, darauf erfolgt eine komplette Ausschaltung des Anzeigearrays. Wird die im System einstellbare Helligkeit variiert, so gilt, dass bei einer höheren Helligkeit die Leuchtdauer für jede Anzeigearrayzeile bzw. Bildzeile größer ist.

Erfindungsgemäße bidirektionale Displays können OLED-Mikrodisplays mit verschachtelter Aktivmatrix sein.

Es kann sich jedoch ebenso um separate Anzeigearrays und Kameraarrays auf einem CMOS-Schaltkreis handeln. Durch die erfindungsgemäß ebenfalls vorgeschlagene Vorgehensweise zur Auslegung der IR-Bestrahlungsquelle kann innerhalb der Kamerapixelzellen im bidirektionalen OLED-Mikrodisplay der maximal mögliche Photostrom $I_{ph}$ erzeugt werden. Durch Definition dieses Photostroms kann mit Gleichung 1 die minimal erforderliche Integrationszeit $T_{int}$ ermittelt werden. Bei einer nicht optimalen und zu groß gewählten Integrationszeit steigt der Aufwand beim Schaltungsentwurf, die Systemfrequenz sowie die Leistungsaufnahme nimmt zu und die Zuverlässigkeit des Systems sinkt aufgrund der hohen Frequenz.

Unter Nutzung der optimal bestimmten Integrationszeit $T_{int}$ können die erfindungsgemäßen sequentiellen elektrischen Ansteuerungen eingesetzt werden, um Störungen durch optisches und/oder elektrisches Überkoppeln zwischen OLED- und Kamerapixeln zu vermeiden. Im Ergebnis kann ein auf Basis des erfindungsgemäßen Displays realisiertes HMD-System bei einer optimierten Leistungsaufnahme und einer störungsfreien Bildaufnahme betrieben werden. Weiterhin ist durch die erfindungsgemäße sequentielle elektrische Ansteuerung auch eine Helligkeitssteuerung möglich.

Hoch miniaturisierte Blickverfolgungs-HMDs können somit robust betrieben werden. Auch kann die Displayhelligkeit ohne weitere externe Schaltungskomponenten, wie z.B. Kathodenspannungsregler, variabel eingestellt werden.

**Patentansprüche**

1. Bidirektionales Display mit einem zweidimensionalen Anzeigearray (1) umfassend mehrere lichterzeugende Bildelemente (1a, 1b) und einem zweidimensionalen Kameraarray (2) umfassend mehrere lichterfassende Elemente (2a, 2b),und
   Mittel zur Ansteuerung des Anzeigearrays (1) und des Kameraarrays (2), die dazu gebildet sind das Anzeigearray (1) und das Kameraarray (2) sequentiell elektrisch anzusteuern,
   wobei die beiden Arrays (1, 2) zumindest abschnittsweise ineinander verschachtelt und/oder überlagert angeordnet sind
   **dadurch gekennzeichnet, dass**
   die beiden Arrays (1, 2) jeweils zeilenweise elektrisch ansteuerbar sind, und
   dass die Mittel zur sequentiellen elektrischen Ansteuerung des Anzeigearrays (1) und des Kameraarrays (2) so ausgebildet sind, dass während einer Lichterzeugung in einer Zeile (1za1) des Anzeigearrays (1) eine Lichterfassung mit der dieser Zeile (1za1) nächstliegenden Zeile (2zk1) des Kameraarrays (2) deaktiviert ist, womit eine zeilensequentielle elektrische Ansteuerung des bidirektionalen Displays realisiert ist.

2. Bidirektionales Display nach dem vorhergehenden Anspruch
   **gekennzeichnet durch**
   ein für das menschliche Auge sichtbares Licht emittierendes Anzeigearray (1), bevorzugt ein darüber hinaus kein Infrarotlicht emittierendes Anzeigearray (1),
   und/oder
   ein Infrarotlicht erfassendes Kameraarray (2), bevorzugt ein darüber hinaus kein für das menschliche Auge sichtbares Licht erfassendes Kameraarray (2).

3. Bidirektionales Display nach einem der vorhergehenden Ansprüche
   **dadurch gekennzeichnet, dass**
   das Anzeigearray (1) OLEDs als lichterzeugende Bildelemente (1a, 1b) aufweist
   und/oder
   dass das Kameraarray Photodioden oder Phototransistoren als lichterfassende Elemente (2a, 2b) aufweist
   und/oder
   dass die lichterzeugenden Bildelemente (1a, 1b) und/oder die lichterfassenden Elemente (2a, 2b) entweder als separate oder als ineinander verschachtelte, sowie in CMOS Technologie ausgebildete und/oder integrierte Matrizen realisiert sind
   und/oder
   dass das bidirektionale Display ein Mikrodisplay mit einer Seitenlänge der lichterzeugenden Bildelemente (1a, 1b) im Bereich zwischen 4 μm und 40 μm und/oder einer Seitenlänge der lichterfassenden Elemente (2a, 2b) im Bereich zwischen 4 μm und 40 μm ist.

4. Verfahren zur zeitlich gesehen sequentiellen elektrischen Ansteuerung eines bidirektionalen Displays, bei dem
   ein bidirektionales Display, das ein zweidimensionales, mehrere lichterzeugende Bildelemente (1a, 1b) umfassendes

EP 2 715 804 B1

Anzeigearray (1) und ein zweidimensionales mehrere lichterfassende Elemente (2a, 2b) umfassendes Kameraarray (2), und Mittel zur Ansteuerung des Anzeigearrays (1) und des Kameraarrays (2), die dazu ausgebildet sind, das Anzeigearray (1) und das Kameraarray (2) sequentiell elektrisch anzusteuern, aufweist,

wobei die beiden Arrays (1, 2) zumindest abschnittsweise ineinander verschachtelt angeordnet sind, eingesetzt wird, und

die beiden Arrays (1, 2) jeweils zeilenweise elektrisch angesteuert werden, und dabei so angesteuert werden, dass während einer Lichterzeugung in einer Zeile (1za1) des Anzeigearrays (1) eine Lichterfassung mit der dieser Zeile (1za1) nächstliegenden Zeile (2zk1) des Kameraarrays (2) deaktiviert wird, so dass eine zeilensequentielle elektrische Ansteuerung des bidirektionalen Displays realisiert wird.

5. Verfahren nach dem vorhergehenden Anspruch
*dadurch gekennzeichnet, dass*
während der Lichterzeugung in mehreren, bevorzugt benachbarten Zeilen (1za1, 1za2) des Anzeigearrays (1) die Lichterfassung mit den diesen mehreren Zeilen (1za1, 1za2) nächstliegenden Zeilen (2zk1, 2zk2) des Kameraarrays (2) deaktiviert wird.

6. Verfahren nach einem der vorhergehenden Ansprüche 4 oder 5
*dadurch gekennzeichnet, dass*
während einer Lichterzeugung in einer Zeile (1za1) des Anzeigearrays (1) eine Lichterfassung mit einer Zeile des Kameraarrays, die nicht die dieser Zeile (1za1) des Anzeigearrays (1) nächstliegende Zeile (2zk1) des Kameraarrays ist, bevorzugt mit der von dieser Zeile (1za1) des Anzeigearrays (1) am weitesten entfernt angeordneten Zeile (2zkL) des Kameraarrays, ermöglicht wird.

7. Verfahren nach einem der Ansprüche 4 bis 6
*dadurch gekennzeichnet, dass*
eine elektrische Ansteuerung des Anzeigearrays (1) und des Kameraarrays (2), bei der während einer Lichterfassung mit einer, mehreren oder allen Zeile(n) (2zk1, 2zk2) des Kameraarrays (2) in einer oder mehreren Zeile(n) (1za1, 1za2) des Anzeigearrays (1) ein Programmieren letzterer Zeile(n) und/oder ein Einschreiben von in letzterer/n Zeile(n) darzustellenden Daten in letztere Zeile(n), nicht jedoch ein Darstellen von Daten in letzterer/n Zeile(n) ermöglicht wird.

8. Verfahren nach einem der Ansprüche 4 oder 5
*dadurch gekennzeichnet, dass*
während des Belichtens zumindest eines Teils des Kameraarrays (2) mit einer externen Lichtquelle (3), insbesondere mit einer Infrarot-Lichtquelle, und/oder während der Lichterfassung mit einer, mehreren oder allen Zeile(n) (2zk1, 2zk2) des Kameraarrays (2) in keiner der Zeilen des Anzeigearrays (1) eine Lichterzeugung und/oder eine elektrische Aktivität ermöglicht wird.

9. Verfahren nach einem der Ansprüche 4 oder 5
*dadurch gekennzeichnet, dass*
während einer Lichterzeugung in irgendeiner der Zeilen des Anzeigearrays (1) jegliche Lichterfassung mit dem Kameraarray (2) deaktiviert wird, also durch eine zeitlich gesehen vollständige Separation der elektrischen Ansteuerung des Anzeigearrays (1) und der elektrischen Ansteuerung des Kameraarrays (2).

10. Verfahren nach einem der Ansprüche 4 bis 9
*dadurch gekennzeichnet, dass*
für mindestens eine, bevorzugt für mehrere, bevorzugt für alle Zeile(n) (1za1, 1za2) des Anzeigearrays zwischen dem Ende eines Programmierens dieser Zeile(n) und/oder dem Ende eines Einschreibens von in dieser/n Zeile(n) darzustellenden Daten in diese Zeile(n) einerseits und dem Beginn der Lichterfassung mit einer, mehreren oder allen Zeile(n) (2zk1, 2zk2) des Kameraarrays (2) andererseits ein vorbestimmtes Zeitintervall $\Delta t$ eingehalten wird, dessen Länge bevorzugt mindestens 1/10, bevorzugt mindestens 1/5, bevorzugt mindestens die Hälfte der Zeitdauer $\Delta t_{KE}$ der Lichterfassung mit der/den Zeile(n) (2zk1, 2zk2) des Kameraarrays (2) beträgt.

11. Verfahren nach einem der vorhergehenden Ansprüche 4 bis 10
*dadurch gekennzeichnet, dass*
für alle Zeilen (1za1, 1za2) des Anzeigearrays (1) die Zeitdauer $t_{AE}$ der Lichterzeugung gleich lang eingehalten wird und/oder
dass für alle Zeilen (1za1, 1za2) des Anzeigearrays (1) die Zeitdauer $t_{AD}$ der Deaktivierung der Lichterzeugung und/oder der elektrischen Deaktivierung und/oder des Abschaltens der jeweiligen Zeile gleich lang eingehalten wird.

12. Verfahren nach einem der Ansprüche 4 bis 11
**_dadurch gekennzeichnet, dass_**
die Lichterfassung in allen Zeilen (2zk1, 2zk2) des Kameraarrays (2) in ein und demselben Zeitintervall $t_{KE}$ erfolgt und dass die Lichterzeugung in den einzelnen Zeilen (1za1, 1za2) des Anzeigearrays (1) zeitlich versetzt zueinander und für alle Zeilen des Anzeigearrays (1) außerhalb des Zeitintervalls $t_{KE}$ erfolgt
oder
dass sowohl die Lichterfassung in den einzelnen Zeilen (2zk1, 2zk2) des Kameraarrays (2) als auch die Lichterzeugung in den einzelnen Zeilen (1za1, 1za2) des Anzeigearrays (1) zeitlich versetzt zueinander erfolgt, wobei für alle Zeilen des Anzeigearrays (1) die Lichterfassung in der jeweils nächstliegenden Zeile des Kameraarrays (2) außerhalb des Zeitintervalls der Lichterzeugung erfolgt.

13. Verfahren nach einem der Ansprüche 4 bis 12
**_dadurch gekennzeichnet, dass_**
mit Lichterzeugung in einer Zeile (1za1, 1za2) des Anzeigearrays (1) gemeint ist, dass

• ein Einschreiben von in dieser Zeile darzustellenden Daten in diese Zeile und/oder Programmieren dieser Zeile, eine Darstellen von Daten in dieser Zeile und ein Löschen von dargestellten Daten aus dieser Zeile durchgeführt wird,
• lediglich das vorbeschriebene Einschreiben und/oder Programmieren einerseits und das vorbeschriebene Darstellen andererseits durchgeführt wird,
• lediglich das vorbeschriebene Darstellen und das vorbeschriebene Löschen durchgeführt wird oder
• ausschließlich das vorbeschriebene Darstellen durchgeführt wird.

14. Verfahren nach einem der Ansprüche 4 bis 13
**_dadurch gekennzeichnet, dass_**
mit Lichterfassung in einer Zeile (2zk1, 2zk2) des Kameraarrays (2) gemeint ist, dass

• eine Einschaltverzögerung bis zum Beginn der nachfolgend beschriebenen Integration, eine Integration von von einer externen Lichtquelle (3) ausgehenden und auf die Zeile auftreffenden Lichtquanten und ein Auslesen des so integrierten Zeilensignals durchgeführt wird,
• lediglich die vorbeschriebene Einschaltverzögerung und die vorbeschriebene Integration durchgeführt wird,
• lediglich die vorbeschriebene Integration und das vorbeschriebene Auslesen durchgeführt wird

oder

• ausschließlich die vorbeschriebene Integration durchgeführt wird.

15. Verfahren nach einem der Ansprüche 4 bis 14
**_dadurch gekennzeichnet, dass_**
mehrere aufeinanderfolgende Lichterzeugungen durch die einzelnen Zeilen (1za1, 1za2) des Anzeigearrays (1) entsprechend mehrerer darzustellender Displaybilder oder Frames durchgeführt werden, wobei zu jeder dieser Lichterzeugungen eine Lichterfassung durch das Kameraarray (1) gemäß einem der vorhergehenden Ansprüche erfolgt.

16. Verwendung eines bidirektionalen Displays oder eines Verfahrens zur Ansteuerung eines bidirektionalen Displays nach einem der vorhergehenden Ansprüche im Bereich der Blickverfolgung, insbesondere der Blickverfolgung im Bereich von kopfbefestigten Displays, der augengesteuert-interaktiven erweiterten Realität, von blickgesteuerten Bildsuchern in Digitalkameras und/oder von blickgesteuerten Nutzersteuerungen bei Mikroskopen, insbesondere zum blickgesteuerten Bewegen eines Mikroskoptischs, insbesondere eines Kreuztischs.

**Claims**

1. Bidirectional display having a two-dimensional display array (1) comprising a plurality of light-generating picture elements (1a, 1b) and a two-dimensional camera array (2) comprising a plurality of light-detecting elements (2a, 2b), and

means for controlling the display array (1) and the camera array (2), which are designed for a sequential electrical control of the display array (1) and the camera array (2),

wherein the two arrays (1, 2) are arranged nested in one another and/or superimposed on one another at least section-wise,

**characterized in that**

the two arrays (1, 2) can each be electrically controlled at least row-wise, and

the means for sequential electrical control of the display array (1) and the camera array (2) are designed so that, during a light generation in a row (1za1) of the display array (1), a light detection by the row (2zk1) of the camera array (2) next closest to this row (1za1) is deactivated, whereby a row-sequential electrical control of the bidirectional display is realized.

2. Bidirectional display in accordance with the preceding claim,
   **characterized by**
   a display array (1) emitting light visible to the human eye, preferably a display array (1) not emitting infrared light beyond this,
   and/or
   a camera array (2) detecting infrared light, preferably a camera array (2) not detecting any light visible to the human eye beyond this.

3. Bidirectional display in accordance with one of the preceding claims,
   **characterized in that**
   the display array (1) includes OLEDs as light-generating picture elements (1a, 1b), and/or
   the camera array includes photodiodes or phototransistors as light-detecting elements (2a, 2b)
   and/or
   **in that** the light-generating picture elements (1a, 1b) and/or the light-detecting elements (2a, 2b) are realized either as separate matrices or as mutually nested matrices or as matrices formed and/or integrated in CMOS technology and/or
   **in that** the bidirectional display is a microdisplay having a side length of the light-generating picture elements (1a, 1b) in the range between 4 $\mu$m and 40 $\mu$m and/or having a side length of the light-detecting elements (2a, 2b) in the range between 4 $\mu$m and 40 $\mu$m.

4. Method of sequential, from a time aspect, electrical control of a bidirectional display,
   wherein
   a bidirectional display is used which has: a two-dimensional display array (1) comprising a plurality of light-generating picture elements (1a, 1b) and a two-dimensional camera array (2) comprising a plurality of light-detecting elements (2a, 2b), and means for controlling the display array (1) and the camera array (2), which are designed to control the display array (1) and the camera array (2) electrically in a sequential manner,
   wherein the two arrays (1, 2) are arranged nested in one another at least section-wise, and
   the two arrays (1, 2) are each electrically controlled row-wise, and thereby are controlled so that, during a light generation in a row (1za1) of the display array (1), a light detection by the row (2zk1) of the camera array (2) next closest to this row (1za1) is deactivated so that a row-sequential electrical control of the bidirectional display is realized.

5. Method in accordance with the preceding claim,
   **characterized in that**
   during the light generation in a plurality of rows (1za1, 1za2), preferably adjacent rows of the display array (1), the light detection by the rows (2zk1, 2zk2) of the camera array (2) next closest to this plurality of rows (1za1, 1 za2) is deactivated.

6. Method in accordance with one of the preceding claims 4 or 5,
   **characterized in that**
   a light detection is enabled during a light generation in a row (1za1) of the display array (1) by a row of the camera array which is not the row (2zk1) of the camera array next closest to this row (1za1) of the display array (1), preferably by the row (2zkL) of the camera array arranged furthest away from this row (1za1) of the display array (1).

7. Method in accordance with any of claims 4 to 6,
   **characterized in that**
   an electrical control of the display array (1) and of the camera array (2), in which, during a light detection by one row, a plurality of rows or all rows (2zk1, 2zk2) of the camera array (2) in one or more rows (1za1, 1za2) of the display array (1), a programming of the latter row(s) and/or a writing of data to be represented in the latter row(s) is enabled in the latter row(s), but not a representation of data in the latter row(s).

8. Method in accordance with any of claims 4 or 5,
**characterized in that**
during the exposure of at least a part of the camera array (2) by an external light source (3), in particular by an infrared light source, and/or during the light detection by one row, a plurality of rows or all rows (2zk1, 2zk2) of the camera array (2), a light generation and/or an electrical activity is not enabled in any of the rows of the display array (1).

9. Method in accordance with any of claims 4 or 5,
**characterized in that**
during a light generation in any of the rows of the display array (1), any and all light detection by the camera array (2) is deactivated, that is, in a time aspect, by a complete separation of the electrical control of the display array (1) and of the electrical control of the camera array (2).

10. Method in accordance with any of claims 4 to 9,
**characterized in that**
a predefined time interval $\Delta t$ whose length preferably amounts to 1/10, preferably at least 1/5, preferably at least half the time duration $\Delta t_{KE}$ of the light detection by the row(s) (2zk1, 2zk2) of the camera array (2) (lies for) at least one row, preferably for a plurality of rows, preferably for all rows (1za1, 1za2) of the display array between the end of a programming of this/these row(s) and/or the end of a writing of data to be represented in this/these row(s) into this/these row(s), one the one hand, and the start of the light detection by one row, a plurality of rows or all rows (2zk1, 2zk2) of the camera array (2), on the other hand.

11. Method in accordance with any of the preceding claims 4 to 10,
**characterized in that**
the time duration $t_{AE}$ of the light generation is of equal length for all rows (1za1, 1za2) of the display array (1) and/or
**in that**, for all rows (1za1, 1za2) of the display array (1), the time duration $t_{AD}$ of the deactivation of the light generation and/or of the electrical deactivation and/or of the switching off of the respective row is of equal length.

12. Method in accordance with any of claims 4 to 11,
**characterized in that**
the light detection in all rows (2zk1, 2zk2) of the camera array (2) takes place in one and the same time interval $t_{KE}$; and **in that** the light generation takes place in the individual rows (1za1, 1za2) of the display array (1) with a time offset from one another and outside the time interval $t_{KE}$ for all rows of the display array (1)
or
**in that** both the light detection in the individual rows (2zk1, 1zk2) of the camera array (2) and the light generation in the individual rows (1za1, 1za2) of the display array (1) takes place mutually offset in time, with the light detection for all rows of the display array (1) taking place in the respective next closest row of the camera array (1) outside the time interval of the light generation.

13. Method in accordance with any of claims 4 to 12,
**characterized in that**
light generation in a row (1za1, 1za2) of the display array (1)

   • means a writing of data to be represented in this row into this row and/or programming of this row, a representation of data in this row and a deletion of represented data from this row,
   • means only the above-described writing and/or programming, one the one hand, and the above-described representation, one the other hand,
   • means only the above-described representation and the above-described deletion
   or
   • means only the above-described representation.

14. Method in accordance with any of claims 4 to 13,
**characterized in that**
light generation in a row (2zk1, 2zk2) of the camera array (2)

• means a switch-on delay up to the start of the integration described in the following, an integration of light quants emanating from an external light source (3) and incident onto the row and a reading out of the row signal integrated in this manner,
• means only the above-described switch-on delay and the above-described integration,
• means only the above-described integration and the above-described reading out
or
• means only the above-described integration.

**15.** Method in accordance with any of claims 4 to 14,
**characterized in that**
a plurality of mutually following light generations by the individual rows (1za1, 1za2) of the display array (1) takes place corresponding to a plurality of display images or frames to be represented, with a light detection by the camera array (1) in accordance with one of the preceding claims taking place for each of these light generations.

**16.** Use of a bidirectional display or of a method of controlling a bidirectional display in accordance with one of the preceding claims in the field of eye-tracking, in particular in eye-tracking in the field of head-mounted displays, of eye-controlled and interactive augmented reality, of gaze-controlled viewfinders in digital cameras and/or of gaze-controlled user controls in microscopes, in particular for the gaze-controlled movement of a microscope stage, in particular of an xy-stage.

## Revendications

**1.** Afficheur bidirectionnel avec un tableau d'affichage (1) bidimensionnel comprenant une pluralité d'éléments d'image (1a, 1b) de génération de lumière et un tableau de caméra (2) bidimensionnel comprenant une pluralité d'éléments de détection de lumière (2a, 2b), et
des moyens pour la commande du tableau d'affichage (1) et du tableau de caméra (2) étant conçus pour la commande électrique séquentielle du tableau d'affichage (1) et du tableau de caméra (2),
dans lequel les deux tableaux (1, 2) sont agencés imbriqués l'un dans l'autre et/ou superposés l'un sur l'autre au moins par sections,
**caractérisé en ce que**
les deux tableaux (1, 2) peuvent chacun être commandés électriquement au moins par rangées, et
les moyens pour la commande électrique séquentielle du tableau d'affichage (1) et du tableau de caméra (2) sont conçus de telle manière que, lors de la génération de lumière dans une rangée (1za1) du tableau d'affichage (1), une détection de lumière par la rangée (2zk1) du tableau de caméra (2) la plus proche de ladite rangée (1za1) soit désactivée en réalisant une commande électrique séquentielle par rangée de l'afficheur bidirectionnel.

**2.** Afficheur bidirectionnel selon la revendication précédente,
**caractérisé par**
un tableau d'affichage (1) émettant de la lumière visible à l'oeil humain, de préférence un tableau d'affichage (1) n'émettant pas de la lumière infrarouge au-delà,
et/ou
un tableau de caméra (2) détectant de la lumière infrarouge, de préférence un tableau de caméra (2) ne détectant aucune lumière visible à l'oeil humain au-delà.

**3.** Afficheur bidirectionnel selon l'une quelconque des revendications précédentes,
**caractérisé en ce que**
le tableau d'affichage (1) comprend des OLEDS en tant qu'éléments d'image (1a, 1b) de génération de lumière,
et/ou
le tableau de caméra comprend des photodiodes ou des phototransistors en tant qu'éléments de détection de lumière (2a, 2b)
et/ou
**en ce que** les éléments d'image (1a, 1b) de génération de lumière et/ou les éléments de détection de lumière (2a, 2b) sont réalisés soit en tant que matrices séparées soit en tant que matrices mutuellement imbriquées ainsi en tant que matrices étant formées et/ou intégrées en technologie CMOS.
et/ou
**en ce que** l'afficheur bidirectionnel est un microafficheur ayant une langueur de côté des éléments d'image de génération de lumière (1a, 1b) dans la plage entre 4 μm et 40 μm et/ou ayant une longueur de côté des éléments de détection de lumière (2a, 2b) dans la plage entre 4 μm et 40 μm.

4. Procédé pour la commande électrique séquentielle, du point de vue temporel, d'un afficheur bidirectionnel, dans lequel

un afficheur bidirectionnel est utilisé, qui présente: un tableau d'affichage (1) bidimensionnel comprenant une pluralité d'éléments d'image de génération de lumière (1a, 1b) et un tableau de camera (2) bidimensionnel comprenant une pluralité d'éléments de détection de lumière (2a, 2b), et de moyens pour la commande du tableau d'affichage (1) et du tableau de caméra (2) qui sont conçus pour la commande électrique séquentielle du tableau d'affichage (1) et du tableau de caméra (2),

dans lequel les deux tableaux (1, 2) sont agencés imbriqués l'un dans l'autre au moins en sections, et les deux tableaux (1, 2) sont chacun commandés électriquement par rangée, et ainsi sont commandés de telle manière que, lors d'une génération de lumière dans une rangée (1za1) du tableau d'affichage (1), une détection de lumière par la rangée (2zk1) du tableau de caméra (2) la plus proche de cette rangée (1za1) soit désactivée afin de qu'une commande électrique séquentielle par rangée de l'afficheur bidirectionnel soit réalisée.

5. Procédé selon la revendication précédente,
caractérisé en ce que
lors de la génération de lumière dans une pluralité de rangées (1za1, 1za2), de préférence dans les rangées adjacentes du tableau d'affichage (1), la détection de lumière par les rangées (2zk1, 2zk2) du tableau de caméra (2) les plus proches à ladite pluralité de rangées (1za1, 1 za2) soit désactivée.

6. Procédé selon l'une quelconque des revendications précédentes 4 ou 5,
caractérisé en ce qu'
une détection de lumière est permise lors d'une génération de lumière dans une rangée (1za1) du tableau d'affichage (1) par une rangée du tableau de caméra qui n'est pas la rangée (2zk1) du tableau de caméra la plus proche de ladite rangée (1za1) du tableau d'affichage (1), de préférence par la rangée (2zkL) du tableau de caméra la plus éloignée de ladite rangée (1za1) du tableau d'affichage (1).

7. Procédé selon l'une quelconque des revendications 4 à 6,
caractérisé en ce qu'
une commande électrique du tableau d'affichage (1) et du tableau de caméra (2), dans laquelle, lors d'une détection de lumière par une rangée, une pluralité de rangées ou toutes les rangées (2zk1, 2zk2) du tableau de caméra (2) dans une rangée ou dans plusieurs rangées (1za1, 1za2) du tableau d'affichage (1), une programmation da la dernière/les dernières rangée(s) et/ou une écriture des données à représenter dans la dernière/les dernières rangée(s) est permise dans la dernière/les dernières rangée(s), mais pas une représentation des données dans la dernière/les dernières rangée(s).

8. Procédé selon l'une quelconque des revendications 4 ou 5,
caractérisé en ce que
lors de l'exposition d'au moins une partie du tableau de caméra (2) par une source de lumière externe (3), en particulier par une source de lumière infrarouge, et/ou lors de la détection de lumière par une rangée, une pluralité de rangées ou toutes les rangées (2zk1, 2zk2) du tableau de caméra (2), une génération de lumière et/ou une activité électrique ne sont pas permises dans aucune des rangées du tableau d'affichage (1).

9. Procédé selon l'une quelconque des revendications 4 ou 5,
caractérisé en ce que
lors d'une génération de lumière dans une quelconque des rangées du tableau d'affichage (1), toute détection de lumière par le tableau de caméra (2) est désactivée, c'est-à-dire, du point de vue temporel, par une séparation complète de la commande électrique du tableau d'affichage (1) et de la commande électrique du tableau de caméra (2).

10. Procédé selon l'une quelconque des revendications 4 à 9,
caractérisé en ce qu'
un intervalle de temps Δt prédéfinit ayant une longueur de préférence d'au moins 1/10, de préférence au moins de 1/5, de préférence au moins la moitié de la durée de temps $\Delta T_{KE}$ de la détection de lumière par la/les rangée(s) (2zk1, 2zk2) du tableau de camera (2) est situé au moins pour une rangée, de préférence pour une pluralité de rangées, de préférence pour toutes les rangées (1za1, 1za2) du tableau d'affichage entre la fin d'une programmation de ladite/lesdites rangée(s) et/ou la fin d'une écriture des données à représenter dans ladite/lesdites rangée(s) en-dedans de ladite/lesdites rangée(s), d'une part, et le début de la détection de lumière par une rangée, une pluralité de rangées ou toutes les rangées (2zk1, 2zk2) du tableau de caméra (2), d'autre part.

11. Procédé selon l'une quelconque des revendications précédentes 4 à 10,
**caractérisé en ce que**
la durée de temps $t_{AE}$ de la génération de lumière est de longueur identique pour toutes les rangées (1za1, 1za2) du tableau d'affichage (1)
et/ou
**en ce que**, pour toutes les rangées (1za1, 1za2) du tableau d'affichage (1), la durée de temps $t_{AD}$ de la désactivation de la génération de lumière et/ou de la désactivation électrique et/ou de l'arrêt de la rangée respective est de longueur identique.

12. Procédé selon l'une quelconque des revendications 4 à 11,
**caractérisé en ce que**
la détection de lumière dans toutes les rangées (2zk1, 2zk2) du tableau de caméra (2) est effectuée dans un seul et même intervalle de temps $t_{KE}$; et **en ce que** la génération de lumière est effectuée dans les rangées (1za1, 1za2) individuelles du tableau d'affichage (1) avec un décalage temporel $t_{KE}$ l'une par rapport à l'autre pour toutes les rangées du tableau d'affichage (1)
ou
**en ce que** la détection de lumière dans les rangées (2zk1, 1zk2) individuelles du tableau de caméra (2) ainsi que la génération de lumière dans les rangées (1za1, 1za2) individuelles du tableau d'affichage (1) s'effectuent avec un décalage temporel l'une par rapport à l'autre, avec la détection de lumière pour toutes les rangées du tableau d'affichage (1) s'effectuant dans la rangée respective la plus proche du tableau de caméra (1) hors de l'intervalle de temps de la génération de lumière.

13. Procédé selon l'une quelconque des revendications 4 à 12,
**caractérisé en ce que**
la génération de lumière dans une rangée (1za1, 1za2) du tableau d'affichage (1)

- signifie une écriture de données à représenter dans ladite rangée en-dedans de ladite rangée et/ou la programmation de ladite rangée, une représentation de données dans ladite rangée et un effacement des données représentées dans ladite rangée;
- signifie seulement l'écriture décrite au-dessus et/ou la programmation, d'une part, et la représentation décrite ci-dessus, d'autre part;
- signifie seulement la représentation décrite ci-dessus et l'effacement décrit au-dessus;
ou
- signifie seulement la représentation décrite ci-dessus.

14. Procédé selon l'une quelconque des revendications 4 à 13,
**caractérisé en ce que**
la génération de lumière dans une rangée (2zk1, 2zk2) du tableau de caméra (2)

- signifie un retard d'arrêt jusqu'au début de l'intégration décrite dans le suivant, une intégration de quants de lumière émanent d'une source de lumière externe (3) et incident sur la rangée et une lecture du signal de rangée intégré de telle manière,
- signifie seulement le retard d'arrêt décrit ci-dessus et l'intégration décrite ci-dessus,
- signifie seulement l'intégration décrite ci-dessus et la lecture décrite ci-dessus;
ou
- signifie seulement l'intégration décrite ci-dessus.

15. Procédé selon l'une quelconque des revendications 4 à 14,
**caractérisé en ce qu'**
une pluralité de générations de lumière mutuellement subséquentes par les rangées (za1, 1za2) individuelles du tableau d'affichage (1) s'effectue conformément avec une pluralité d'images d'affichage ou de trames à représenter, avec une détection de lumière par le tableau de caméra (1) conformément avec l'une quelconque des revendications précédentes s'effectuant pour chacune desdites générations de lumière.

16. Utilisation d'un afficheur bidirectionnel ou d'un procédé de commande d'un afficheur bidirectionnel selon l'une

**EP 2 715 804 B1**

quelconque des revendications précédentes dans le domaine du suivi oculaire, en particulier le suivi oculaire dans le domaine d'afficheurs montés sur la tête, dans le domaine de réalité commandée visuellement et augmentée de manière interactive, dans le domaine de viseurs commandés par le regard dans les caméras numériques et/ou dans le domaine de commandes d'utilisateur commandées par le regard dans les microscopes, in particulier pour le mouvement commandé par le regard d'une platine de microscope, en particulier d'une platine xy.

Fig. 1

EP 2 715 804 B1

Fig. 2

Fig. 3

Fig. 4

letzte Zeile Kamera (2zk(L))

$t_{KE}$

Display

1za1 Erste Zeile

V4

Letzte Zeile

$t_{AE}$   $t_{AD}$

$t_{AE}$   $t_{LE}$   $t_{AK}$   $t_{AD}$

Display

Erste Zeile

V5

1za(2L) Letzte Zeile

$t_{AE}$   $t_{AD}$

Display aus                          Kamera aus : Außerhalb von

Programmierung Display               Kamera auslesen

Display leuchtend                    Lichterfassung Kamera

EP 2 715 804 B1

Fig. 5

EP 2 715 804 B1

Bidirektionale Optik

Bidirektionales OLED - Mikrodisplay

| Bidirektionale Optik -> Transmission | Kamera-Pixelzelle -> Spannung | Analog-Digital Wandler |

Menschliches Auge -> Reflexion

Photodiode -> Stromwandlung

IR-Bestrahlungsquelle der Augenszene -> Photonen Emitter

OLED-Schichtstapel -> Transmission

Spaltensignalaufbereitung

Photonen · Strom · Digitaldaten · Photonen · Spannung · Strom · Photonen · Spannung

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006030541 A1
- US 20060145365 A
- US 20030117369 A

**In der Beschreibung aufgeführte Nicht-Patentliteratur**

- **J. P. ROLLAND ; H. HUA ; P. KRISHNASHWAMY.** Video-based eye tracking methods and algorithms in head-mounted displays. *optics express,* 2006, vol. 14, 4328-4350